# EUROPÄISCHE PATENTSCHRIFT

(11) **EP 3 621 969 B1**
(45) Veröffentlichungstag und Bekanntmachung des Hinweises auf die Patenterteilung: **20.04.2022**
(21) Anmeldenummer: 18725441.2
(22) Anmeldetag: 08.05.2018
(51) Int. Cl.: C07F 1/08, C09K 11/06, H01L 51/00, H01L 51/50

(54) **CUPRATVERBINDUNGEN SOWIE VERFAHREN ZU DEREN HERSTELLUNG UND ANWENDUNGSMÖGLICHKEITEN**
CUPRATE COMPOUNDS, AND METHOD FOR THE PRODUCTION THEREOF AND POSSIBLE USES
LIAISONS CUPRATE ET LEUR PROCÉDÉ DE PRODUCTION, ET POSSIBILITÉS D'APPLICATION

(30) Priorität: 09.05.2017 DE 102017207804
(43) Veröffentlichungstag der Anmeldung: 18.03.2020
(73) Patentinhaber: Universität Bremen, 28359 Bremen (DE)
(72) Erfinder: BECKMANN, Jens, 28203 Bremen (DE); VOGT, Matthias, 28193 Bremen (DE); OLARU, Marian, 28215 Bremen (DE)
(74) Vertreter: Maikowski & Ninnemann Patentanwälte Partnerschaft mbB
(86) Internationale Anmeldenummer: PCT/EP2018/061905
(87) Internationale Veröffentlichungsnummer: WO 2018/206595

(56) Entgegenhaltungen:
- KELLY CHEN ET AL: "Subtle Modulation of Cu 4 X 4 L 2 Phosphine Cluster Cores Leads to Changes in Luminescence", INORGANIC CHEMISTRY, Bd. 54, Nr. 13, 6. Juli 2015 (2015-07-06), Seiten 6245-6256, XP055485475, EASTON, US ISSN: 0020-1669, DOI: 10.1021/acs.inorgchem.5b00443
- YI JIANG ET AL: "Novel electrochemi-/photo-luminescence of Ag 3 Cu 5 heterometallic alkynyl clusters", DALTON TRANSACTIONS, Bd. 44, Nr. 9, 1. Januar 2015 (2015-01-01) , Seiten 3941-3944, XP055485473, GB ISSN: 1477-9226, DOI: 10.1039/C4DT03369H
- ANDREAS SCHNEPF ET AL: "Ge8R6: The ligands define the bonding situation within the cluster core", DALTON TRANSACTIONS, Nr. 20, 1. Januar 2005 (2005-01-01), Seite 3277, XP055485956, GB ISSN: 1477-9226, DOI: 10.1039/b508379f

## Beschreibung

Die vorliegende Erfindung betrifft eine Cupratverbindung gemäß dem Oberbegriff des Anspruchs 1, die Verwendung einer solchen Cupratverbindung gemäß dem Oberbegriff des Anspruchs 8, eine organische Leuchtdiode gemäß dem Oberbegriff des Anspruchs 9 sowie ein Verfahren zur Herstellung einer solchen Cupratverbindung gemäß dem Oberbegriff des Anspruchs 10.

Organische Leuchtdioden (OLEDs) werden als kostengünstige und effiziente Technologie für flexible Displays oder innovative Flächenbeleuchtung diskutiert. Eine signifikante Problemstellung ist es dabei, Materialien zu verwenden, die frei von seltenen, und somit teuren, Edelmetallen sind. Neue optoelektronische Substanzen müssen dabei eine hohe Stabilität gegenüber Luft und Wasser aufweisen, da diese im Herstellungsprozess (insbesondere während der Beschichtung und des Druckens) der Dioden nicht zu vermeiden sind.

Chen et al. beschreiben eine Reihe von Cu₄X₄(PPh₂py)₂-Verbindungen (X = Cl (1), Br (2), I (3), PPh2py = 2-(Diphenylphosphino)pyridin), die mittels Röntgenkristallographie, NMR, UV-VIS und Lumineszenzspektroskopie charakterisiert wurden (Chen, Kelly, Jason Shearer, and Vincent J. Catalano. "Subtle modulation of Cu4X4L2 phosphine cluster cores leads to changes in luminescence." Inorganic chemistry 54.13 (2015): 6245-6256).

Jiang et al. beschreiben zwei windmühlenartige Ag₃Cu₅-Alkinyl-Cluster, die neuartige Photolumineszenz- und Elektrochemilumineszenz-Eigenschaften aufweisen, die durch Änderung des Substituenten an den Alkynyl-Liganden modifiziert werden konnten (Jiang, Yi, et al. "Novel electrochemi-/photo-luminescence of Ag3Cu5 heterometallic alkynyl clusters." Dalton Transactions 44.9 (2015): 3941-3944).

Schnepf et al. beschreiben, dass die Disproportionierungsreaktion von Ge(I)-Halogeniden einen Weg zu Clusterverbindungen mit einer mittleren Oxidationsstufe der Germaniumatome innerhalb des Clusterkerns zwischen 0 und 1 eröffnet, wobei gleichzeitig Verbindungen mit Germanium in einer Oxidationsstufe größer als I gebildet werden. (Schnepf, Andreas, and Christian Drost. "Ge 8 R 6: The ligands define the bonding situation within the cluster core." Dalton Transactions 20 (2005): 3277-3280).

Der vorliegenden Erfindung liegt die Aufgabe zugrunde, neuartige Verbindungen anzugeben, die zur Verwendung in einer organischen Leuchtdiode geeignet sind.

Diese Aufgabe wird mit einer Cupratverbindung mit den Merkmalen des Anspruchs 1 gelöst.

Eine solche Cupratverbindung entspricht einer der nachstehenden Formeln (I) oder (XIII):

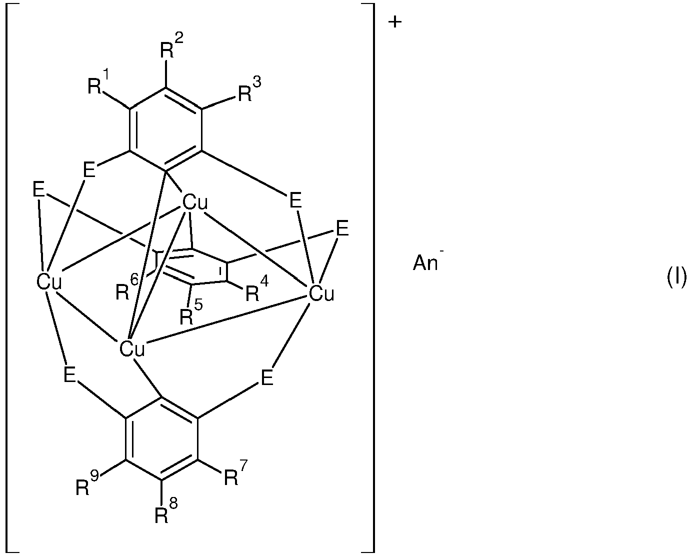

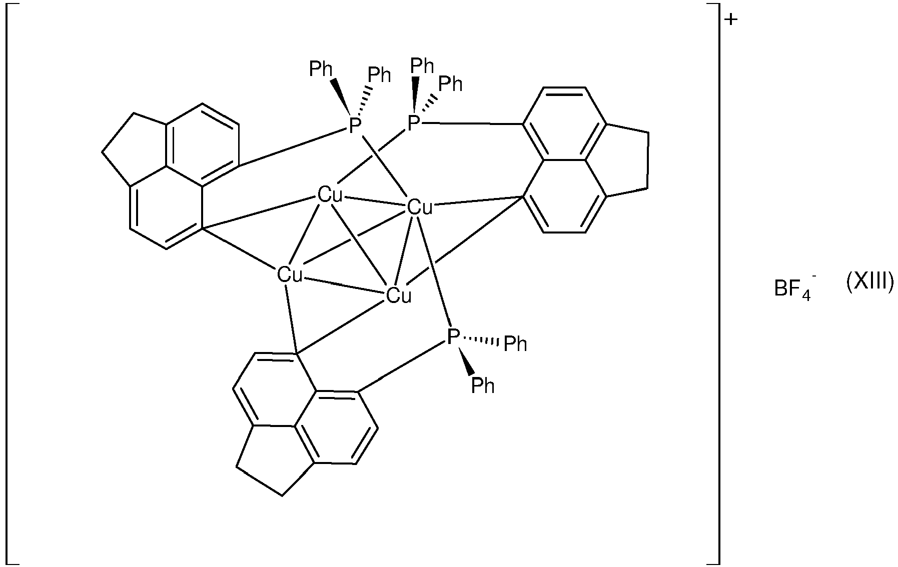

Dabei haben die in diesen Formeln angegebenen Reste folgende Bedeutungen:
- R¹, R², R³, R⁴, R⁵, R⁶, R⁷, R⁸, R⁹: bedeutet H, X, substituiertes oder nicht substituiertes C₁-C₁₀-Alkyl, substituiertes oder nicht substituiertes C₁-C₁₀-Alkenyl oder substituiertes oder nicht substituiertes C₆-C₂₀-Aryl, wobei das C₁-C₁₀-Alkyl, das C₁-C₁₀-Alkenyl und das C₆-C₂₆-Aryl jeweils durch ein oder mehrere Stickstoff-, Sauerstoff- und/oder Schwefelatome unterbrochen sein kann,
- X: bedeutet F, Cl, Br, I, NO₂, N(R^{1'}R^{2'}), wobei R^{1'}, R^{2'} unabhängig von anderen Resten R^{1'}, R^{2'} im selben Molekül H, substituiertes oder nicht substituiertes C₁-C₁₀-Alkyl, substituiertes oder nicht substituiertes C₁-C₁₀-Alkenyl oder substituiertes oder nicht substituiertes C₆-C₂₀-Aryl bedeutet, wobei das C₁-C₁₀-Alkyl, das C₁-C₁₀-Alkenyl und das C₆-C₂₆-Aryl jeweils durch ein oder mehrere Stickstoff-, Sauerstoff- und/oder Schwefelatome unterbrochen sein kann,
- E: ist unabhängig von anderen Resten E im selben Molekül ein Rest der allgemeinen Formel NR2, PR2 oder OR, wobei jeder Rest R unabhängig von anderen Resten R im selben Molekül H, X, substituiertes oder nicht substituiertes C₁-C₁₀-Alkyl, substituiertes oder nicht substituiertes C₁-C₁₀-Alkenyl oder substituiertes oder nicht substituiertes C₆-C₂₆-Aryl bedeutet, wobei das C₁-C₁₀-Alkyl, das C₁-C₁₀-Alkenyl und das C₆-C₂₆-Aryl jeweils durch ein oder mehrere Stickstoff-, Sauerstoff- und/oder Schwefelatome unterbrochen sein kann,
- Ph: ein Phenylrest und
- An⁻: ist ein beliebiges Anion.

Ferner wird eine Cupratverbindung der allgemeinen Formel (II) offenbart:

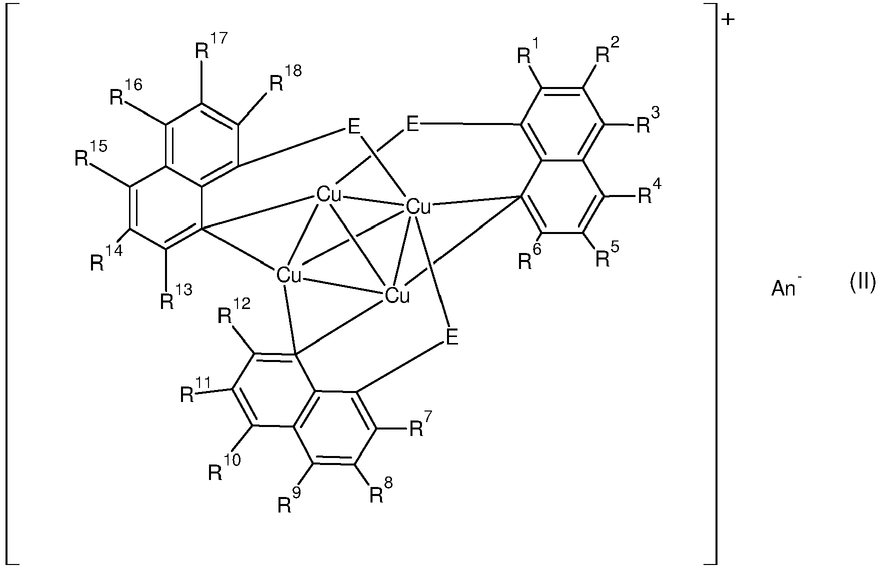

Dabei haben die in dieser Formel angegebenen Reste folgende Bedeutungen:
R¹, R²_{,} R³, R⁴, R⁵, R⁶, R⁷, R⁸, R⁹, R¹⁰, R¹¹, R¹², R¹³, R¹⁴, R¹⁵, R¹⁶, R¹⁷, R¹⁸ bedeutet H, X, substituiertes oder nicht substituiertes C₁-C₁₀-Alkyl, substituiertes oder nicht substituiertes C₁-C₁₀-Alkenyl oder substituiertes oder nicht substituiertes C₆-C₂₀-Aryl, wobei das C₁-C₁₀-Alkyl, das C₁-C₁₀-Alkenyl und das C₆-C₂₆-Aryl jeweils durch ein oder mehrere Stickstoff-, Sauerstoff- und/oder Schwefelatome unterbrochen sein kann,

Die weiteren Reste haben die zur Formel (I) angegebene Bedeutung.

Einige Kohlenstoffatome in den dargestellten Cupratverbindungen weisen eine höhere Koordinationszahl als die für kohlenstofftypische Koordinationszahl 4 auf. Dies ist bei Cupraten jedoch üblich und im Stand der Technik bereits hinlänglich beschrieben.

Ein Beispiel für ein substituiertes C₁-Alkyl ist eine Methoxygruppe oder eine Methylolgruppe.

Eine derartige Cupratverbindung erfüllt die folgenden grundsätzlichen Anforderungen an ein OLED-Materialien: A) eine intensive Lumineszenz, B) eine leicht zugängliche Synthese aus günstigen Ausgangsstoffen, C) eine hohe Löslichkeit und D) eine sehr gute Stabilität, die eine industrielle Verarbeitung zulässt.

Die erfindungsgemäßen Cupratverbindungen zeigen eine besondere Effizienz in ihrer Lumineszenz und können aus relativ günstigen Ausgangstoffen (Kupfersalze und einfache organische Liganden) hergestellt werden. Die Cupratverbindungen weisen dabei eine sterische Abschirmung der Cu-Atome durch große organische Liganden/Reste auf.

So befinden sich die Kupferatome im Inneren der Moleküle, während die organischen Liganden die Kupferatome umgeben. Dies führt zu einer guten Stabilisierung der Kupferatome und zu einer hohen Komplexstabilität insgesamt. Die Cupratverbindungen sind insbesondere gegenüber einer Oxidation und einer Hydrolyse stabil. Ihre lumineszierenden Eigenschaften bleiben auch in Lösung erhalten. Damit eignen sich diese Cupratverbindungen als robuste und kostengünstige Materialien für OLEDs.

Gemeinsames Strukturmerkmal der Cupratverbindungen ist ein zentrales Cu₄-Cluster, wobei Kupfer-Kohlenstoff-Bindungen (Cu-C-Bindungen) ausgebildet sind. Trotz unterschiedlicher möglicher Synthesewege lassen sich durch die vorliegende Erfindung Substanzen des Typs [R₃CU₄]⁺ An⁻ herstellen.

Die Cupratverbindungen sind kationisch und weisen eine gute Löslichkeit in polaren Lösungsmitteln auf. Das Besondere der erfindungsgemäßen Cupratverbindungen ist darin zu sehen, dass das Strukturmotiv des Cuprats, also eine eigentlich labile und empfindliche Cu-C-Bindung, mittels einer sterischen Abschirmung der Cu-Atome durch große organische Liganden/Reste geschützt ist, sodass dieses Motiv als robustes Strukturmerkmal überraschenderweise für photolumineszente Kupfercluster nutzbar wird.

Das Gegenanion ist für die Funktion der Cupratverbindungen unerheblich. Es hat sich allerdings gezeigt, dass die Synthese der Cupratverbindungen bei Verwendung bestimmter Gegenanion besonders einfach durchgeführt werden kann, da das Gegenanion die Löslichkeit der Cupratverbindungen beeinflusst.

Die konkrete Ausgestaltung der organischen Liganden, die das Kupfer-Cluster umgeben, spielt für die Funktionalität der Cupratverbindungen ebenso nur eine untergeordnete Rolle. Hier sind insbesondere sterische und elektrostatische Beschränkungen bei der Auswahl möglicher Reste zu berücksichtigen, wie dies dem Fachmann allgemein geläufig ist.

In einer Variante ist der Rest E ein Rest der allgemeinen Formel (III), (IV) oder (V), wobei eine oder mehrere kovalente Bindungen zum Rest E über das in der Formel (III) dargestellte Phosphoratom, über das in der Formel (IV) dargestellte Stickstoffatom oder über das in der Formel (V) dargestellte Sauerstoffatom ausgebildet sind, 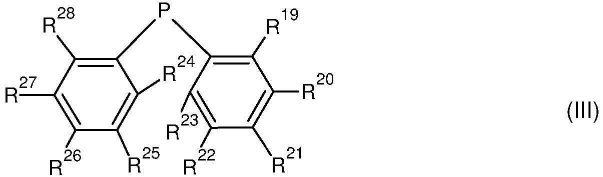 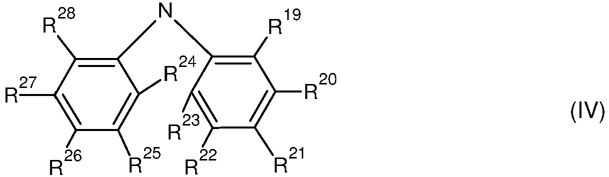 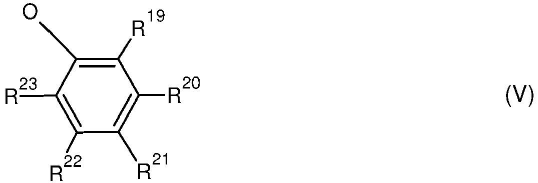 wobei
R¹⁸, R¹⁹, R²⁰, R²¹, R²², R²³, R²⁴, R²⁵, R²⁶, R²⁷, R²⁸
H, X, substituiertes oder nicht substituiertes C₁-C₁₀-Alkyl, substituiertes oder nicht substituiertes C₁-C₁₀-Alkenyl oder substituiertes oder nicht substituiertes C₆-C₂₆-Aryl bedeutet, wobei das C₁-C₁₀-Alkyl, das C₁-C₁₀-Alkenyl und das C₆-C₂₆-Aryl jeweils durch ein oder mehrere Stickstoff-, Sauerstoff- und/oder Schwefelatome unterbrochen sein kann.

In einer Variante entspricht der Rest E der allgemeinen Formel PR2 (wie etwa P(CH₃)₂) oder der allgemeinen Formel (III), ist also ein Phosphanrest. Beispielsweise kann es sich um einen unsubstituierten organischen Phosphanrest handeln, der der allgemeinen Formel (XII) entspricht und der über die gestrichelt dargestellten Bindungen mit dem restlichen Molekül der allgemeinen Formel (I) oder (II) verbunden ist:

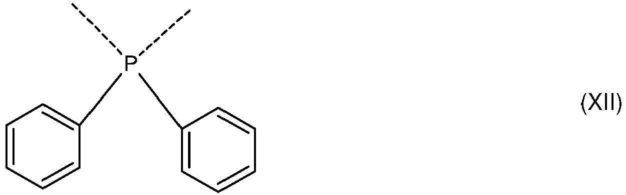

In einer Variante entspricht die Cupratverbindung der allgemeinen Formel (I).

In einer Variante weisen in der Formel (I) die Reste R¹, R⁴ und R⁷ eine erste gemeinsame Bedeutung, die Reste R², R⁵ und R⁸ eine zweite gemeinsame Bedeutung sowie die Reste R³, R⁶ und R⁹ eine dritte Bedeutung auf. Dabei können die erste Bedeutung, die zweite Bedeutung und die dritte Bedeutung identisch, teilweise identisch oder aber unterschiedlich sein. "Teilweise identisch" bedeutet dabei, dass zwei der drei Bedeutungen identisch sind, während die dritte Bedeutung von den anderen beiden Bedeutungen abweicht. Beispielsweise ist es möglich, dass die erste Bedeutung und die dritte Bedeutung H ist, während die zweite Bedeutung ein substituiertes oder nichtsubstituiertes Alkyl gemäß den obigen Definitionen ist.

Hierdurch offenbart wird die Möglichkeit, dass in der Formel (II) die Reste R¹, R⁷ und R¹³ eine erste Bedeutung, die Reste R², R⁸ und R¹⁴ eine zweite Bedeutung, die Reste R³, R⁹ und R¹⁵ eine dritte Bedeutung, die Reste R⁴, R¹⁰ und R¹⁶ eine vierte Bedeutung, die Reste R⁵, R¹¹ und R¹⁷ eine fünfte Bedeutung sowie die Reste R⁶, R¹² und R¹⁸ eine sechste Bedeutung auf. Dabei können die erste Bedeutung, die zweite Bedeutung, die dritte Bedeutung, die vierte Bedeutung, die fünfte Bedeutung und die sechste Bedeutung identisch, teilweise identisch oder aber unterschiedlich sein. "Teilweise identisch" bedeutet dabei, dass mindestens zwei der drei Bedeutungen identisch sind, während die verbliebenen Bedeutungen von den anderen, untereinander identischen Bedeutungen abweicht. Dabei ist es auch möglich, dass Gruppen identischer Bedeutungen gebildet werden, beispielsweise also die erste und dritte Bedeutung identisch sind, die zweite und vierte Bedeutung identisch sind und die fünfte und sechste Bedeutung identisch sind. Es ist beispielsweise auch möglich, dass die erste Bedeutung, die dritte Bedeutung und die fünfte Bedeutung H ist, während die zweite Bedeutung, vierte Bedeutung und sechste Bedeutung ein substituiertes oder nichtsubstituiertes Alkyl gemäß den obigen Definitionen ist.

In einer weiteren Variante weisen alle in der Cupratverbindung vorhandenen Reste R¹ bis R⁹ und R¹⁹ bis R²⁸ dieselbe Bedeutung auf. Beispielsweise kann allen in der Cupratverbindung vorhandenen Resten R¹ bis R⁹ und R¹⁹ bis R²⁸ die Bedeutung H zukommen. In diesem Fall liegen die organischen Gruppen in der Cupratverbindung unsubstituiert vor.

Auch für die Formel (II) wird die Möglichkeit offenbart, dass alle in der Cupratverbindung vorhandenen Reste R¹ bis R²⁸ dieselbe Bedeutung aufweisen. Beispielsweise kann allen in der Cupratverbindung der Formel (II) vorhandenen Resten R¹ bis R²⁸ die Bedeutung H zukommen. In diesem Fall liegen die organischen Gruppen in der Cupratverbindung der Formel (II) unsubstituiert vor.

In einer Variante ist das Gegenanion An⁻ ein schwach-koordinierendes Anion.

In einer Variante ist das Gegenanion An⁻ ausgewählt aus der Gruppe bestehend aus [BF₄]⁻, PF₆⁻, AsF₆⁻, SbF₆⁻, O₃SCF₃⁻ , CB₁₁H₁₂⁻, (B₁₂H₁₂)²⁻, [B(C₆F₅)]₄⁻, [B(3,5-(CF₃)₂C₆H₃]₄⁻, Al[OC(CF₃)₃]₄⁻ und [BAr^{F}₄]⁻, wobei Ar^{F} ein Rest der allgemeinen Formel (VI) ist: 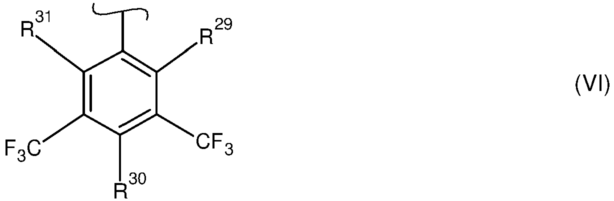 wobei
R²⁹, R³⁰, R³¹
H, X, substituiertes oder nicht substituiertes C₁-C₁₀-Alkyl, substituiertes oder nicht substituiertes C₁-C₁₀-Alkenyl oder substituiertes oder nicht substituiertes C₆-C₂₆-Aryl bedeutet, wobei das C₁-C₁₀-Alkyl, das C₁-C₁₀-Alkenyl und das C₆-C₂₆-Aryl jeweils durch ein oder mehrere Stickstoff-, Sauerstoff- und/oder Schwefelatome unterbrochen sein kann.

[BF₄]⁻ ist dabei als Gegenion besonders gut geeignet, da es für eine hohe Löslichkeit der Cupratverbindungen sorgt.

Wie bereits erläutert, eignen sich die Cupratverbindungen besonders gut zur Verwendung in einer organischen Leuchtdiode. In einem Aspekt betrifft die vorliegende Erfindung daher die Verwendung dieser Cupratverbindungen als Leuchtmittel in einer organischen Leuchtdiode.

In einem weiteren Aspekt betrifft die Erfindung einer organischen Leuchtdiode, die eine Cupratverbindung gemäß den vorherigen Erläuterungen aufweist. Dabei wird die Cupratverbindung als Leuchtmittel in der organischen Leuchtdiode eingesetzt.

Die Cupratverbindungen lassen sich aus günstig bereitstellt Warenrohstoffen in einer sehr einfachen Synthesereaktionen herstellen. Die vorliegende Erfindung betrifft in einem Aspekt auch zwei unterschiedliche Herstellungsverfahren für derartige Cupratverbindung.

Gemäß einem ersten Herstellungsverfahren wird der folgende Schritt zur Herstellung einer Cupratverbindung der allgemeinen Formel (I) durchgeführt:

Umsetzen einer Verbindung der allgemeinen Formel (VII) und/oder einer Verbindung der allgemeinen Formel (VIII) und/oder einer Verbindung der allgemeinen Formel (IX) mit [(CH₃CN)₄Cu][An⁻], wobei An⁻ ein beliebiges Anion ist: 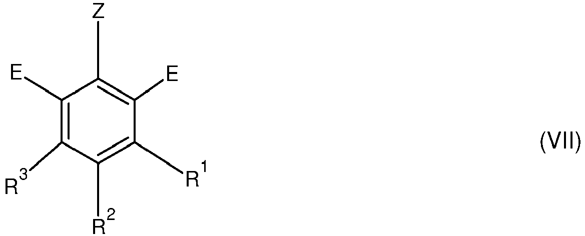 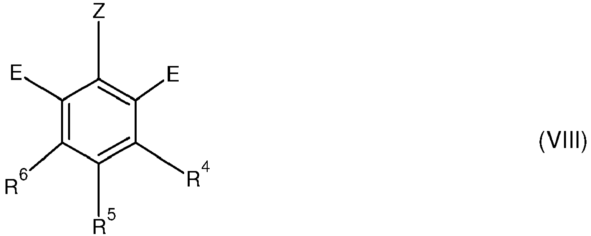 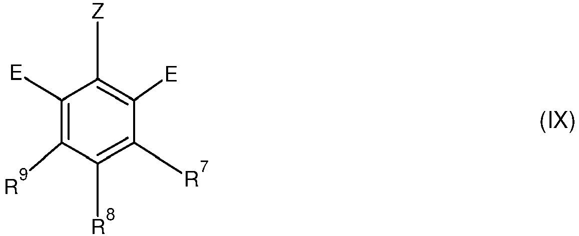 wobei
- R¹, R², R³, R⁴, R⁵, R⁶, R⁷, R⁸, R⁹: H, X, substituiertes oder nicht substituiertes C₁-C₁₀-Alkyl, substituiertes oder nicht substituiertes C₁-C₁₀-Alkenyl oder substituiertes oder nicht substituiertes C₆-C₂₀-Aryl bedeutet, wobei das C₁-C₁₀-Alkyl, das C₁-C₁₀-Alkenyl und das C₆-C₂₆-Aryl jeweils durch ein oder mehrere Stickstoff-, Sauerstoff- und/oder Schwefelatome unterbrochen sein kann,
- X: F, Cl, Br, I, NO₂, N(R^{1'}R^{2'}) bedeutet, wobei R^{1'}, R^{2'} unabhängig von anderen Resten R^{1'}, R^{2'} im selben Molekül H, substituiertes oder nicht substituiertes C₁-C₁₀-Alkyl, substituiertes oder nicht substituiertes C₁-C₁₀-Alkenyl oder substituiertes oder nicht substituiertes C₆-C₂₀-Aryl bedeutet, wobei das C₁-C₁₀-Alkyl, das C₁-C₁₀-Alkenyl und das C₆-C₂₆-Aryl jeweils durch ein oder mehrere Stickstoff-, Sauerstoff- und/oder Schwefelatome unterbrochen sein kann,
- E: unabhängig von anderen Resten E im selben Molekül ein Rest der allgemeinen Formel NR2, PR2 oder OR ist, wobei jeder Rest R unabhängig von anderen Resten R im selben Molekül H, X, substituiertes oder nicht substituiertes C₁-C₁₀-Alkyl, substituiertes oder nicht substituiertes C₁-C₁₀-Alkenyl oder substituiertes oder nicht substituiertes C₆-C₂₆-Aryl bedeutet, wobei das C₁-C₁₀-Alkyl, das C₁-C₁₀-Alkenyl und das C₆-C₂₀-Aryl jeweils durch ein oder mehrere Stickstoff-, Sauerstoff- und/oder Schwefelatome unterbrochen sein kann,
- Z: Si(CH₃)₃ oder Sn((CH₂)₃CH₃)₃ bedeutet.

Der Tributylzinnrest Sn((CH₂)₃CH₃)₃ kann auch verkürzt als SnBu₃ bezeichnet werden.

Die entsprechende Synthesereaktion kann als Eintopfreaktion durchgeführt werden. Dabei wird die in den allgemeinen Formeln (VII), (VIII) und (IX) dargestellte Trimethylsilan-Gruppe durch das Carbanion des eingesetzten organischen Liganden abgespalten. Anschließend kommt es zu einer Selbstorganisation des Cu₄-Clusters mit der in der allgemeinen Strukturformel (I) dargestellten sterischen Abschirmung der Cu-Atome durch große organische Liganden/Reste.

Die Reaktion kann beispielsweise in Tetrahydrofuran (THF) oder einem vergleichbaren organischen Lösungsmittel durchgeführt werden. Geeignete Reaktionstemperaturen liegen im Bereich von 50 bis 95 °C, insbesondere 55 bis 90 °C, insbesondere 60 bis 85 °C, insbesondere 65 bis 80 °C, insbesondere 70 bis 75 °C. Geeignete Reaktionsdauern liegen im Bereich von 1 bis 20 Tage, insbesondere 2 bis 19 Tage, insbesondere 3 bis 18 Tage, insbesondere 4 bis 17 Tage, insbesondere 5 bis 16 Tage, insbesondere 6 bis 15 Tage, insbesondere 7 bis 14 Tage, insbesondere 8 bis 13 Tage, insbesondere 9 bis 12 Tage, insbesondere 10 bis 11 Tage. Besonders geeignete Reaktionsbedingungen sind eine Umsetzungstemperatur von 65 °C bis 85 °C bei einer Reaktionsdauer von 9 bis 12 Tagen.

Gemäß einem nicht beanspruchten weiteren Herstellungsverfahren werden die folgenden Schritte zur Herstellung einer Cupratverbindung der allgemeinen Formel (II) durchgeführt: Umsetzen einer Verbindung der allgemeinen Formel (X) 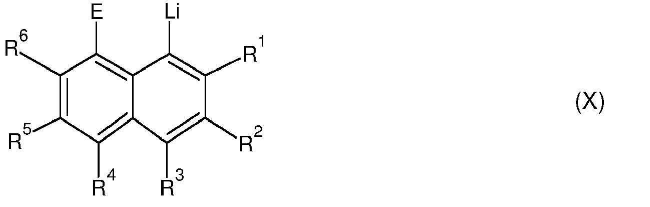 wobei
- R¹, R², R³, R⁴, R⁵, R⁶: H, X, substituiertes oder nicht substituiertes C₁-C₁₀-Alkyl, substituiertes oder nicht substituiertes C₁-C₁₀-Alkenyl oder substituiertes oder nicht substituiertes C₆-C₂₀-Aryl bedeutet, wobei das C₁-C₁₀-Alkyl, das C₁-C₁₀-Alkenyl und das C₆-C₂₆-Aryl jeweils durch ein oder mehrere Stickstoff-, Sauerstoff- und/oder Schwefelatome unterbrochen sein kann,
- X: F, Cl, Br, I, NO₂, N(R^{1'}R^{2'}) bedeutet, wobei R^{1'}, R^{2'} unabhängig von anderen Resten R^{1'}, R^{2'} im selben Molekül H, substituiertes oder nicht substituiertes C₁-C₁₀-Alkyl, substituiertes oder nicht substituiertes C₁-C₁₀-Alkenyl oder substituiertes oder nicht substituiertes C₆-C₂₀-Aryl bedeutet, wobei das C₁-C₁₀-Alkyl, das C₁-C₁₀-Alkenyl und das C₆-C₂₀-Aryl jeweils durch ein oder mehrere Stickstoff-, Sauerstoff- und/oder Schwefelatome unterbrochen sein kann,
- E: unabhängig von anderen Resten E im selben Molekül ein Rest der allgemeinen Formel NR2, PR2 oder OR ist, wobei jeder Rest R unabhängig von anderen Resten R im selben Molekül H, X, substituiertes oder nicht substituiertes C₁-C₁₀-Alkyl, substituiertes oder nicht substituiertes C₁-C₁₀-Alkenyl oder substituiertes oder nicht substituiertes C₆-C₂₆-Aryl bedeutet, wobei das C₁-C₁₀-Alkyl, das C₁-C₁₀-Alkenyl und das C₆-C₂₆-Aryl jeweils durch ein oder mehrere Stickstoff-, Sauerstoff- und/oder Schwefelatome unterbrochen sein kann,

mit SiCl₄ und ZnF₂, um ein Zwischenprodukt der allgemeinen Formel (XI) zu erhalten: 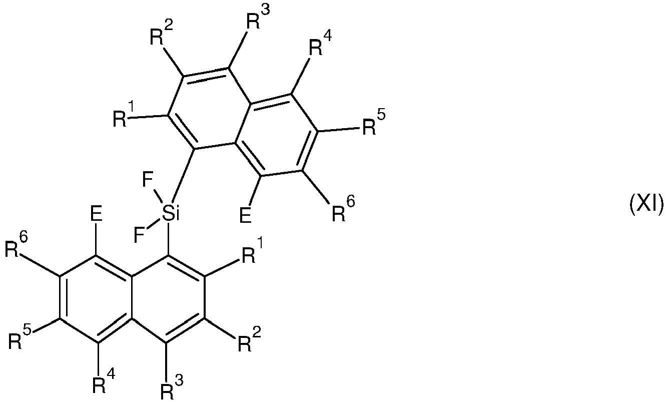 und Umsetzen des Zwischenproduktes der allgemeinen Formel (XI) mit [(CH₃CN)₄Cu][An⁻], wobei An⁻ ein beliebiges Anion ist.

Alternativ ist es auch möglich, mit dem Zwischenprodukt als Ausgangsmaterial zu starten. Das heißt, der Schritt der Synthese des Zwischenproduktes mit der allgemeinen Formel (XI) muss nicht notwendigerweiser Teil des beanspruchten Verfahrens sein.

Die Umsetzung des Zwischenproduktes mit der allgemeinen Formel (XI) zu der erfindungsgemäßen Cupratverbindung kann beispielsweise in Dichlormethan als Lösungsmittel erfolgen. Geeignete Reaktionstemperaturen liegen im Bereich von 0 °C bis 100 °C, insbesondere von 10 °C bis 90 °C, insbesondere von 20 °C bis 80 °C, insbesondere von 30 °C bis 70 °C, insbesondere von 40 °C bis 60 °C insbesondere von 50 °C bis 55 °C. Die Reaktion kann insbesondere in einem Temperaturbereich von 20 °C bis 30 °C, beispielsweise bei Raumtemperatur von 25 °C durchgeführt werden.

Geeignete Reaktionsdauern liegen im Bereich von 1 bis 6 Tagen, insbesondere 2 bis 5 Tagen, insbesondere 3 bis 4 Tagen. Dabei ist eine Reaktionsdauer von 3 bis 4 Tagen bei einer Reaktionstemperatur von 20 bis 30 °C besonders geeignet.

In einer Variante wird als Anion [BF₄]⁻ eingesetzt. Es hat sich herausgestellt, dass die Cupratverbindungen mit diesem Anion eine besonders hohe Löslichkeit aufweisen und sich besonders leicht herstellen lassen.

In einer Variante wird das nach der Synthese in der Cupratverbindung vorhandene Gegenanion durch ein anderes Gegenanion ausgetauscht. Beispielsweise ist vorgesehen, das zunächst erhaltene Produkt mit [Kat⁺][BAr^{F}₄] umzusetzen, wobei Ar^{F} ein Rest der allgemeinen Formel (VI) ist: 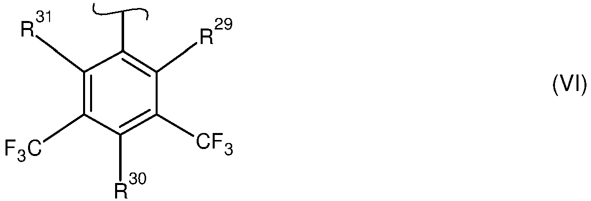 wobei
R²⁹, R³⁰, R³¹
H, X, substituiertes oder nicht substituiertes C₁-C₁₀-Alkyl, substituiertes oder nicht substituiertes C₁-C₁₀-Alkenyl oder substituiertes oder nicht substituiertes C₆-C₂₆-Aryl bedeutet, wobei das C₁-C₁₀-Alkyl, das C₁-C₁₀-Alkenyl und das C₆-C₂₆-Aryl jeweils durch ein oder mehrere Stickstoff-, Sauerstoff- und/oder Schwefelatome unterbrochen sein kann, und
Kat⁺ ein beliebiges Kation bedeutet.

Als Kation besonders geeignet sind einwertige Alkalimetalle wie Natrium und Kalium, insbesondere Natrium.

Sämtliche Varianten der beschriebenen Cupratverbindungen sind in beliebiger Kombinationen auf die beschriebene Verwendung, die organische Leuchtdiode und die beiden Herstellungsverfahren übertragbar, und umgekehrt. Ferner sind die Varianten der Verfahren jeweils von einem auf das andere Verfahren in beliebiger Weise übertragbar.

Details der vorliegenden Erfindung werden anhand von Figuren und Ausführungsbeispielen näher erläutert. Es zeigen:
- Figur 1: ein erstes Reaktionsschema zur Herstellung einer Cupratverbindung der allgemeinen Formel (I);
- Figur 2: ein Reaktionsschema für einen Austausch des Gegenanions der Cupratverbindung aus der Figur 1;
- Figur 3: ein Reaktionsschema zur Herstellung einer Cupratverbindung der Formel (XIII);
- Figur 4: ein Fluoreszenz-Emissionsspektrum der gemäß dem Reaktionsschema der Figur 1 hergestellten Cupratverbindung;
- Figur 5: ein UV-Absorptionsspektrum der gemäß dem Reaktionsschema der Figur 1 hergestellten Cupratverbindung;
- Figur 6: ein Emissionsspektrum der gemäß dem Reaktionsschema der Figur 1 hergestellten Cupratverbindung nach einer Anregung bei 375 nm;
- Figur 7A: eine graphische Darstellung der Bestimmung der Lebensdauer des angeregten Zustandes der gemäß dem Reaktionsschema der Figur 2 hergestellten Cupratverbindung bei 300 K (26,85 °C);
- Figur 7B: eine graphische Darstellung der Bestimmung der Lebensdauer des angeregten Zustandes der gemäß dem Reaktionsschema der Figur 2 hergestellten Cupratverbindung bei 77 K (-196,15 °C);
- Figur 8: ein erstes Reaktionsschema zur Darstellung eines zur Herstellung einer Cupratverbindung der allgemeinen Formel (I) geeigneten Edukts;
- Figur 9: ein ¹H-NMR-Spektrum des gemäß dem Reaktionsschema der Figur 8 hergestellten Edukts;
- Figur 10: ein ¹³C-NMR-Spektrum des gemäß dem Reaktionsschema der Figur 8 hergestellten Edukts;
- Figur 11: ein ³¹P-NMR-Spektrum des gemäß dem Reaktionsschema der Figur 8 hergestellten Edukts;
- Figur 12: ein zweites Reaktionsschema zur Darstellung eines zur Herstellung einer Cupratverbindung der allgemeinen Formel (I) geeigneten Edukts und
- Figur 13: ein zweites Reaktionsschema zur Herstellung einer Cupratverbindung der allgemeinen Formel (I).

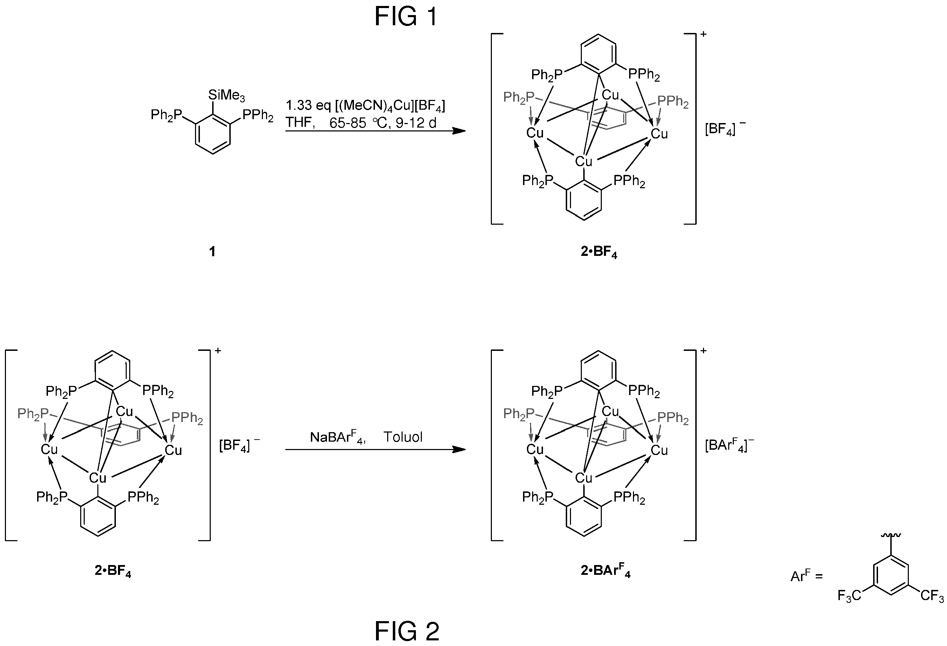

Die Figur 1 zeigt ein erstes Reaktionsschema zur Herstellung einer Cupratverbindung der allgemeinen Formel (I).

### Synthese der Substanz 1

Zur Synthese des Edukts 1 wurde ein 250-ml-Dreihalsrundkolben, der mit einem Rückflusskühler und einem Argoneinlass ausgestattet war, mit Lithium (2,15 g, 307 mmol) und wasserfreiem THF (120 ml) befüllt. Der Inhalt der Flasche wurde auf 0 °C gekühlt. Anschließend wurde Chlordiphenylphosphan (Ph2PCI) (33,9 g, 153 mmol) langsam mittels einer Spritze hinzugefügt. Die Mischung wurde bei einer Temperatur von 0 bis 14 °C über 10 Stunden gerührt. Nach 50 Minuten schlug die Farbe der Mischung nach blutrot um. Zu der Ph₂PCl-Lösung wurde 2,6-F₂C₆H₃Si(CH₃)₃ hinzugegeben (9,0 g, 48 mmol). Diese Verbindung ist beispielsweise in folgenden Publikationen beschrieben: T. D. Yarwood, A. J. Waring, P. Le. Coe, J. Fluor. Chem., 1996, 78, 113-119; B. Bennetau, F.; Rajarison, J.; Dunogues, P. Babin, Tetrahedron,1993, 49, 10843-10854.

Anschließend erfolgte über die nächsten 48 Stunden bei einer Temperatur des umgebenden Ölbads von 90 bis 95 °C eine Reaktion unter Rückfluss. Alle flüchtigen Bestandteile wurden bei reduziertem Druck entfernt, und CH₃CN (150 ml) wurde zu dem halbfesten braunen Rückstand hinzugefügt. Die erhaltene Suspension wurde in Luft über einen Glasfilter gefiltert. Der Feststoff wurde von der Fritte gesammelt und in Chloroform (ca. 150 ml) suspendiert. Die graue Suspension wurde mittels einer Kieselgur-Filterhilfe gefiltert, um Lithiumsalze zu entfernen.

Nachdem alle flüchtigen Bestandteile durch Rotationsverdampfung entfernt wurden, wurde der erhaltene graue Feststoff (16,3 g) durch eine Flash-Chromatographie mit Chloroform gereinigt, wobei Silicagel als stationäre Phase verwendet wurde. Es wurden 14,0 g (54 %) der Substanz 1 als weißer Feststoff erhalten. Die Substanz 1 ist schwach löslich in CH₃CN und Hexan (bei Raumtemperatur). Demgegenüber ist sie in halogenierten Lösungsmitteln (Dichlormethan, Chloroform), aromatischen Lösungsmitteln (Toluol, Benzol), THF und Diethylether löslich.

### Schmelzpunkt: 128 bis 130 °C

**¹H NMR (400 MHz, CDCl₃):** *δ* = 7,36 - 7,28 (m, 12H), 7,29 - 7,19 (m, 8H), 7,12 - 7,09 (m, 3H), 0,57 ppm (t, *J* = 2,6 Hz, 9H);
¹³C **NMR (100 MHz, CDCl₃):** *δ* = 155,47 (t, *J* = 41 Hz), 145,23 (dd, J= 19; 13 Hz), 138,98 - 138,67 (m), 135,94 (s), 133,60 (d, *J =* 20 Hz), 128,70 - 128,34 (multiple signals overlapped), 6,52 ppm (t, J = 14 Hz,);
**³¹P NMR (162 MHz, CDCl₃):** *δ* = -6,43 ppm (s);
**²⁹Si NMR (72 MHz, CDCl₃):** *δ* = -2,99 (t, *J* = 8 Hz).

### Synthese von 2·BF₄

Unter inerten Bedingungen wurde eine Mischung der Verbindung 1 (6,22 g, 12 mmol) und [((CH₃)CN)₄Cu][BF₄] (5,03 g, 16 mmol) in THF (100 ml) über 12 Tage bei 65 bis 85 °C gerührt. Der grüne Feststoff wurde gefiltert und anschließend mit wasserfreiem THF (2 x 50 ml) und Toluol (1 × 60 ml) gewaschen. Der Feststoff wurde unter reduziertem Druck getrocknet. Das Produkt **2·BF₄** (3,60 g, 54 % Rohausbeute) wurde als leuchtend grünes Pulver isoliert. Die Verbindung **2·BF₄** ist schwach löslich in den meisten organischen Lösungsmitteln mit Ausnahme von CH₃CN und einigen halogenierten Lösungsmitteln (Dichlormethan, Chloroform), in denen sie sich langsam zersetzt.

### Schmelzpunkt: über 220 °C.

**¹H NMR (200 MHz, CD₂Cl₂):** *δ* = 7,50 - 6,95 (m, br, 45H), 6,76 (t, *J* = 8 Hz, br, 12H), 6,54 ppm (s, br, 12H);
**¹³C NMR (50 MHz, CD₂Cl₂):** *δ* 146,10 (s, br), 136,31 - 134,89 (m, br), 134,30 - 133,63 (m, br), 133,17 -132,48 (m, br), 132,45 -131,76 (m), 130,92 (s), 129,65 (s, br), 129,56 (s), 129,05 (s, br), 128,35 (s, br);
**³¹P NMR (81 MHz, CD₂Cl₂):** *δ* = 7,66 ppm (s);
**¹⁹F NMR (188 MHz, CD₂Cl₂):** *δ* = -154,62 ppm (br).

### Synthese von 2·BAr^{F}₄

Das Reaktionsschema dieser Synthese ist in der Figur 2 dargestellt.

Unter inerten Bedingungen wurde eine Mischung von **2·BF₄** (200 mg, 0,12 mmol) und NaBAr^{F}₄ (106 mg, 0,12 mmol) in Toluol (10 ml) bei Raumtemperatur gerührt. Dabei löste sich das **2·BF₄** schrittweise, wodurch die Lösung hellgrün wurde. Nach 15 Stunden wurde die Suspension filtriert und das braune Präzipitat verworfen. Das Lösungsmittel wurde bei reduziertem Druck aus dem Filtrat entfernt. Das Produkt **2·BAr^{F}₄** (231 mg, 78 %) wurden als leuchtend grüner Feststoff isoliert. Die Verbindung **2·BAr^{F}₄** ist gut löslich in den meisten organischen Lösungsmitteln mit Ausnahme aliphatischer Lösungsmittel wie Pentan oder Hexan.

### Schmelzpunkt: über 220 °C.

**¹H NMR (200 MHz, THF-*d8*):** *δ* = 7,81 (s, br, 8H), 7,58 (s, 4H), 7,50 - 7,00 (m, 45H), 6,79 (t, *J* = 8 Hz, 12H), 6,58 ppm (s, 12H);
**¹³C NMR (50 MHz, THF-*d8*):** *δ* = 166,38 - 159,33 (m), 146,77 (s, br), 135,11 (s), 136,17 (s, br), 134,68 - 134,33 (m, br), 133,46 (m, br), 130,14 (m, br), 129,63 (s, br), 129,37 (q, br), 129,07 (s),125,02 (q, *J* = 272 Hz), 117,71 (quint, *J* = 4 Hz);
**³¹P NMR (81 MHz, THF-*d8*):** *δ* = 7,81 (s) ppm;
**¹⁹F NMR (188 MHz, THF-*d8*):** *δ* = -64,58 (s) ppm.

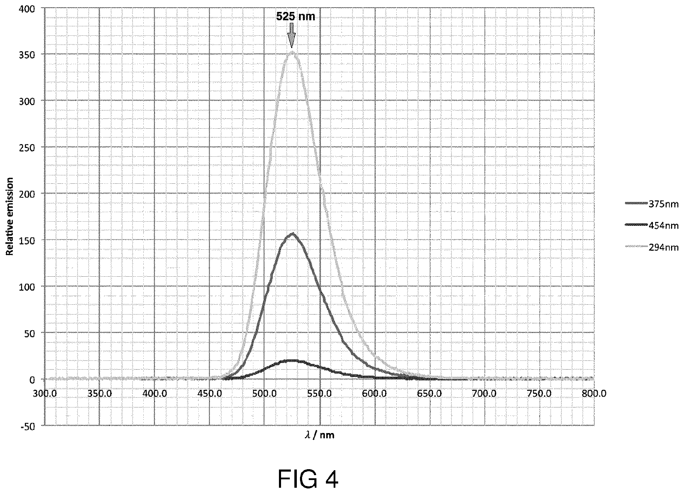

Die nähere Charakterisierung der beiden in diesen Reaktionen erhaltenen Produkte **2·BF₄** und **2·BAr^{F}₄** ist mithilfe der Figuren 4 bis 7B dargestellt.

### Synthese von [Cu₄(Ph₂PAcNaph)₃]BF₄

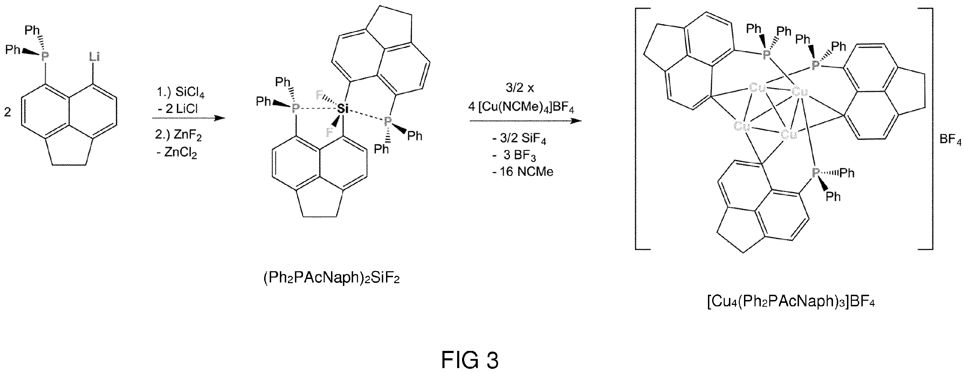

Zunächst wird jedoch ein weiteres Reaktionsschema erläutert, das in der Figur 3 dargestellt ist. Zunächst wurde (Ph2PAcNaph)2SiF2 (mittlere Formel im Reaktionsschema der Figur 2) (100 mg, 0,14 mmol) in 10 ml Dichlormethan gelöst. Sorgfältig zerkleinertes [Cu(CH₃CN)₄]BF₄ (116 mg, 0,37 mmol) wurde anschließend in kleinen Portionen zu der klaren gelben Lösung hinzugefügt. Die Reaktionsmischung wurde über 72 Stunden bei Raumtemperatur gerührt. Die erhaltene gelbe Lösung wurde durch einen PTFE-Spritzenfilter (0,45 µm Porosität) filtriert. Das Filtrat wurde mit n-Hexan (10 ml) überschichtet. Nach langsamer Diffusion kristallisierte das Cu4-Cluster [Cu₄(Ph₂PAcNaph)₃]BF₄ langsam in Form gelblicher Blöcke aus, die für eine nachfolgende Röntgenbeugungsanalyse geeignet waren. Die Ausbeute des kristallinen Materials betrug 40 %.

Die Figur 4 zeigt ein Fluoreszenz-Emissionsspektrum einer Lösung von **2·BF₄** in THF. Dabei erfolgte eine Anregung bei drei verschiedenen Wellenlängen. Das Emissionsmaximum lag bei 525 nm.

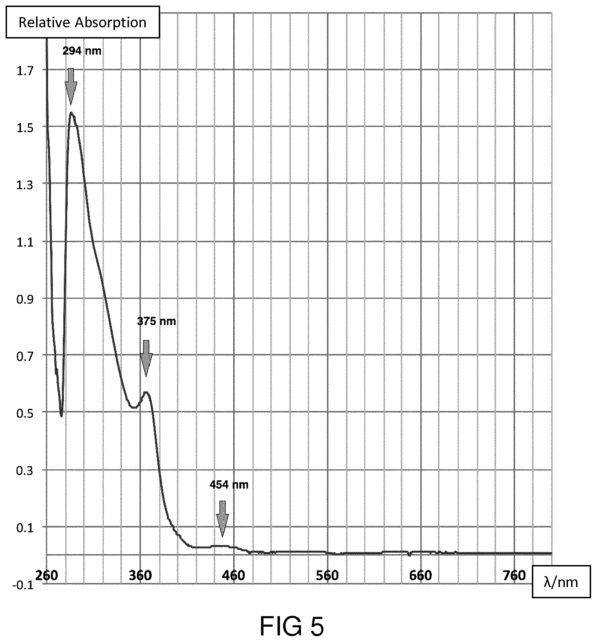

Die Figur 5 zeigt ein UV-Absorptionsspektrum von **2·BF₄** in THF, wobei drei Maxima bei 454 nm, 375 nm und 294 nm ermittelt wurden. Diese Wellenlängen wurden verwendet, um eine Anregung der Substanz zum Erhalt des in der Figur 4 gezeigten Fluoreszenz-Emissionsspektrums zu erreichen.

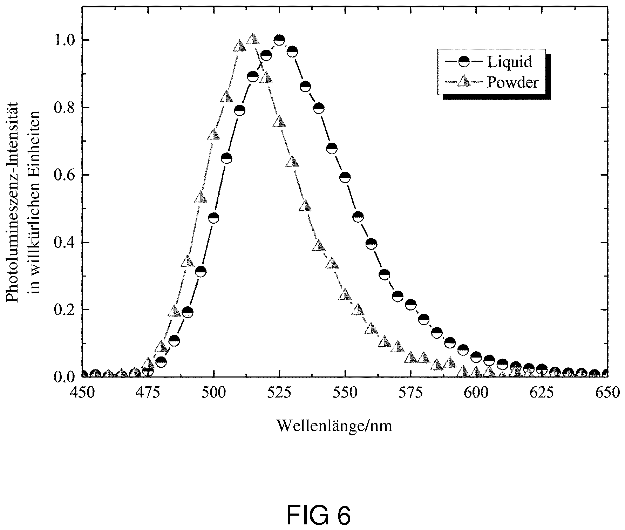

Die Figur 6 zeigt ein weiteres Emissionsspektrum von **2·BF₄**, und zwar in Form eines Feststoffs (Dreiecke) und in Lösung (Kreise) nach einer Anregung bei 375 nm. Dabei ist zu sehen, dass das Emissionsmaximum des Feststoffes leicht zu niedrigeren Wellenlängen verschoben ist.

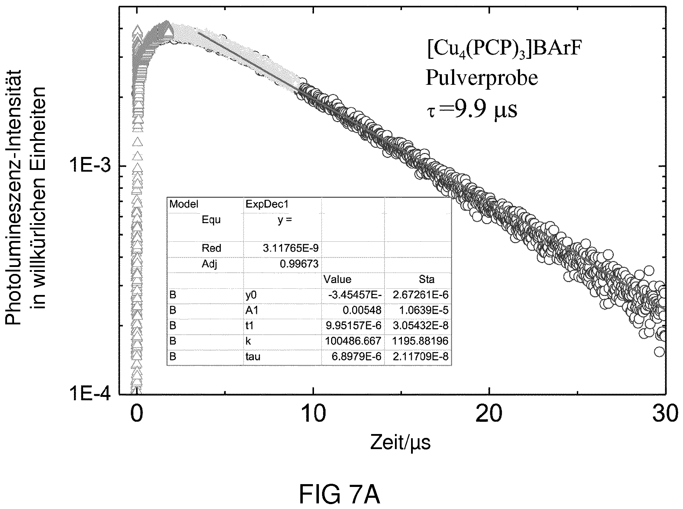

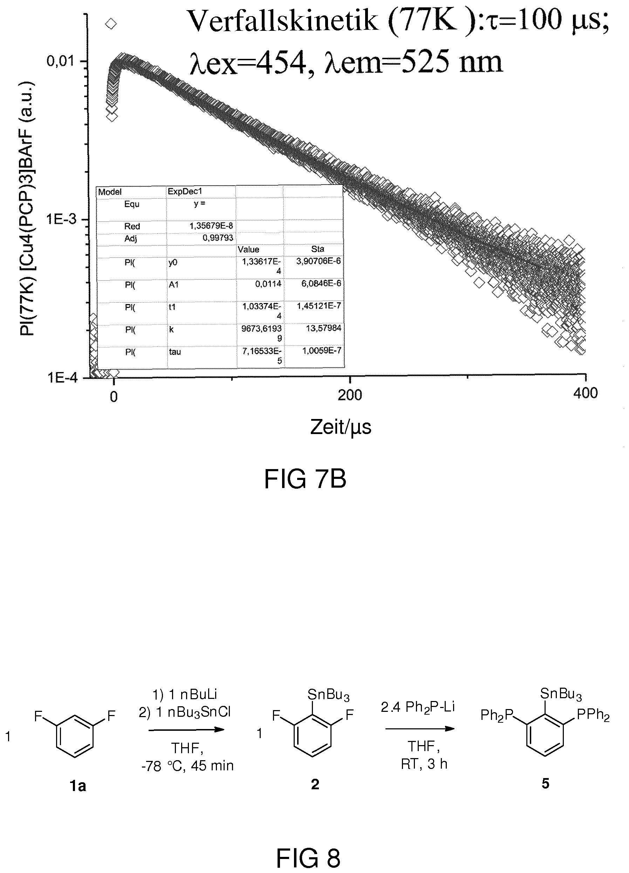

Um die Lebensdauer des angeregten Zustandes der Substanz **2·BAr^{F}₄** zu ermitteln, wurde eine zeitabhängige Bestimmung des aufgrund der Photolumineszenz dieser Substanz emittierten Lichts durchgeführt. Die Ergebnisse sind in den Figuren 7A und 7B dargestellt. Es wurde jeweils der Feststoff untersucht, wobei die Figur 7A die Ergebnisse bei einer Temperatur von 300 K und die Figur 7B die Ergebnisse bei einer Temperatur von 77 K darstellt ("a.u." steht für willkürliche Einheiten). Bei 300 K wurden eine Halbwertszeit und damit eine Lebensdauer des angeregten Zustandes von 9,9 µs ermittelt, während die Halbwertszeit bei 77 K bei 100 µs lag.

Die Figur 8 zeigt ein erstes Reaktionsschema zur Darstellung eines zur Herstellung einer Cupratverbindung der allgemeinen Formel (I) geeigneten Edukts. Die entsprechende Reaktion wird nachfolgend näher beschrieben.

10 mL n-Butyllithium (n-BuLi) (2.5 M in *n*-Hexan, 25 mmol, 1 eq.) wurden langsam bei -80 °C zu 2,85 g 1,3-Difluorbenzol (25 mmol, 1 eq.) **1a** in 20 mL THF hinzugetropft und für 45 Minuten gerührt. Es wurden 8.14 g nBu₃SnCl (25 mmol, 6.78 mL, 1 eq.) tropfenweise hinzugegeben. Das Reaktionsgemisch wurde für weitere 30 Minuten bei -80 °C gehalten und anschließend auf Raumtemperatur erwärmt. Es wurden ca. 70 mL Wasser und 50 mL Et₂O hinzugefügt und das Produkt wässrig aufgearbeitet. Die organische Phase wurde zwei weitere Male mit Wasser und gesättigter NaCI-Lösung gewaschen. Nach der Trocknung über MgSO₄ wurde das Lösungsmittel unter verminderten Druck entfernt. Das Produkt **2** wurde als farblose Flüssigkeit erhalten.

Zur Darstellung des Lithiumdiphenylphosphids wurden 10.84 g Diphenylphosphinchlorid (48.92 mmol, 8.82 mL, 2.4 eq.) langsam zu 0.685 g Lithiumdraht (97.86 mmol, 4.8 eq.) in 60 mL trockenen THF bei -10 °C hinzugetropft. Es wurde für 3 Stunden gerührt. Anschließend wurde das Reaktionsgemisch innerhalb von 18 Stunden auf Raumtemperatur erwärmt. Es erfolgte ein Farbwechsel nach tiefrot. Zu dieser Reaktionslösung wurden langsam 8.06 g Tributyl-2,6-difluorphenyl-stannan (20 mmol, 1 eq.) **2** hinzugetropft. Es wurde mit Hilfe eines kalten Wasserbades gekühlt und für 2 Stunden gerührt. Das Lösungsmittel wurde bei vermindertem Druck entfernt. Es wurde ein schwarzer, öliger Rückstand erhalten, welcher anschließend mit ca. 300 mL trocknem und entgastem *n*-Hexan extrahiert wurde. Das Lösungsmittel wurde im Vakuum entfernt, und der milchige, viskose Rückstand wurde mehrmals unter starkem Rühren und mildem Erhitzen mit trockenem, entgastem Methanol und Acetonitril gewaschen. Als Produkt **5** wurde ein farbloser, klebriger Feststoff erhalten. Die Ausbeute betrug 8.82 g (12 mmol, 60 %).

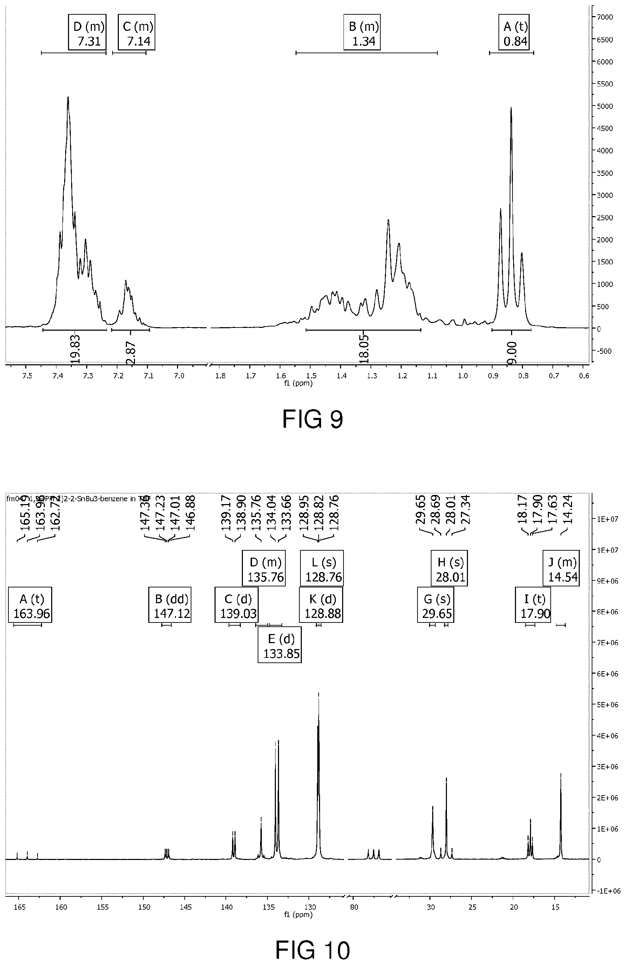

In den Figuren 9, 10 und 11 sind ¹H-, ¹³C- und ³¹P-NMR-Spektren des Produkts 5 gezeigt, wobei folgende NMR-Linien beobachtet werden konnten:
¹H-NMR (CDCl₃, 200 MHz): 7.31 (m, 20 H), 7.14 (m, 3 H), 1.34 (m, 18 H), 0.84 (t, 9 H) ppm.
¹³C-NMR (CDCl₃, 50 MHz): 163.96 (t), 147.12 (dd), 139.03 (d), 135.76 (s), 133.85 (d), 128.88 (d), 128.76 (s), 29.65 (s), 28.01 (s), 17.90 (t), 14.54 (s) ppm.
³¹P-NMR (CDCl₃, 91 MHz): -1.99 (s) ppm.

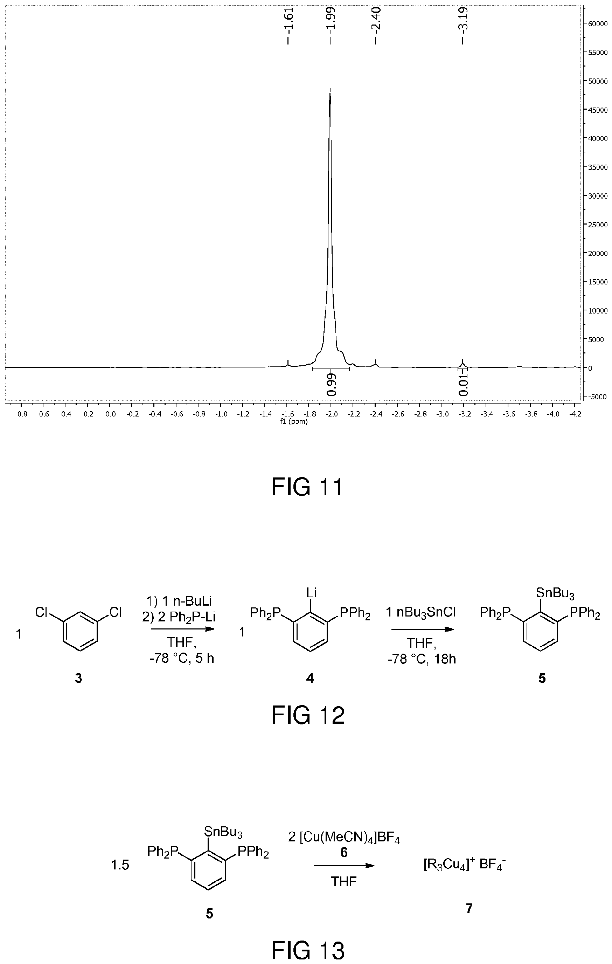

Die Figur 12 zeigt ein zweites Reaktionsschema zur Darstellung eines zur Herstellung einer Cupratverbindung der allgemeinen Formel (I) geeigneten Edukts. Die entsprechende Reaktion wird nachfolgend näher beschrieben.

Zur Darstellung des Lithiumdiphenylphosphids wurden 8.86 g Diphenylphosphinchlorid (40 mmol, 7.38 mL, 2 eq.) zu 0.56g Lithiumdraht (80 mmol, 4 eq.) in 35 mL trockenen THF bei -10 °C langsam hinzugegeben. Es wurde für 3 Stunden gerührt. Anschließend wurde das Reaktionsgemisch innerhalb von 18 Stunden auf Raumtemperatur erwärmt. Es erfolgte ein Farbwechsel nach tiefrot.

In einem separaten Kolben wurden 8 mL n-BuLi (20 mmol, 2.5 M in *n*-Hexan, 1 eq.) bei -78 °C langsam zu 2.92 g 1,3-Dichlorobenzol (20 mmol, 2.27 mL, 1 eq.) **3** in 35 mL trockenem THF hinzugetropft. Es wurde für 1.5 Stunden gerührt.

Die Reaktionslösung wurde bei -78 °C langsam zur beschriebenen Lösung des Lithiumdiphenylphosphids gegeben und bis zum Farbwechsel (dunkelbraun) gerührt. 6.51 g Tributylzinnchlorid (20 mmol, 5.43 mL, 1 eq.) wurden langsam bei -78°C hinzugetropft. Innerhalb von 18 Stunden wurde das Reaktionsgemisch auf Raumtemperatur erwärmt. Es wurde ein schwarzes, viskoses Öl erhalten, welches mit trockenem und entgastem Methanol gewaschen wurde. Abschließend wurde der Rückstand säulenchromatographisch mit dem Laufmittel *n*-Hexan gereinigt. Durch Auskristallisieren aus Methanol konnten für die Einkristall-Röntgenstrukturanalyse geeignete Kristalle erhalten werden. Die Ausbeute betrug 1.32 g (1.8 mmol , 9 %).

Das gemäß dem in Figur 8 bzw. Figur 12 abgebildeten Reaktionsschema hergestellte Produkt 5 diente nachfolgend als Edukt zur Darstellung einer Cupratverbindung der allgemeinen Formel (I). Das entsprechende Reaktionsschema ist in der Figur 13 gezeigt.

Es wurden 74 mg des (2-(Tributylstannyl)-1,3-phenyl)-bis(diphenylphosphins) (0.1 mmol, 1.5 eq.) **5** zu 42 mg des Tetraacetonitrilkupfer(II)-tetrafluoroborans (0.13 mmol, 2 eq.) **6** in 0.6 mL trockenem THF hinzugegeben und für 20 Stunden bei Raumtemperatur gerührt. Das Produkt **7** fiel als grüner Feststoff aus, welcher mit THF gewaschen und im Vakuum getrocknet wurde. Die Ausbeute betrug 60 %.

## Patentansprüche

1. Cupratverbindung gemäß einer der nachstehenden Formeln (I) oder (XIII) 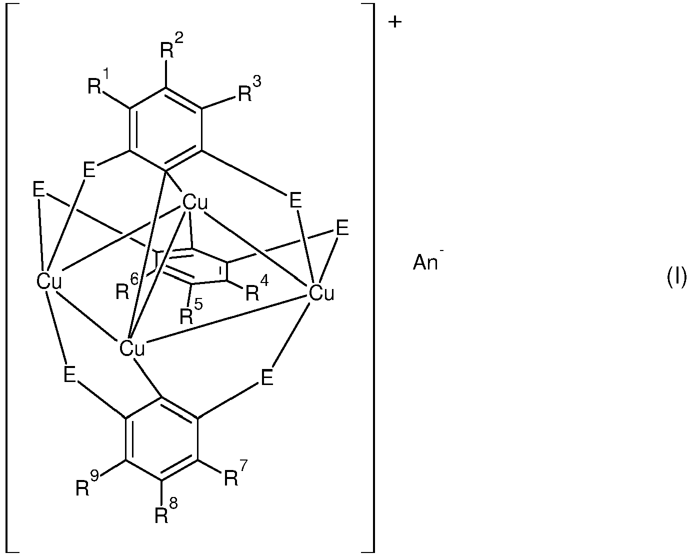 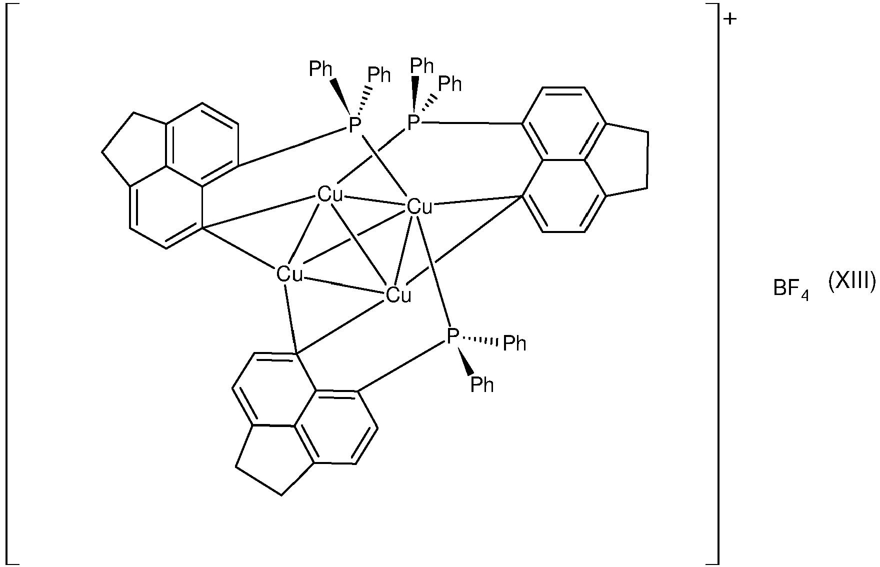 wobei
R¹, R², R³, R⁴, R⁵, R⁶, R⁷, R⁸, R⁹ H, X, substituiertes oder nicht substituiertes C₁-C₁₀-Alkyl, substituiertes oder nicht substituiertes C₁-C₁₀-Alkenyl oder substituiertes oder nicht substituiertes C₆-C₂₀-Aryl bedeutet, wobei das C₁-C₁₀-Alkyl, das C₁-C₁₀-Alkenyl und das C₆-C₂₆-Aryl jeweils durch ein oder mehrere Stickstoff-, Sauerstoff- und/oder Schwefelatome unterbrochen sein kann,
X F, Cl, Br, I, NO₂, N(R^{1'}R^{2'}) bedeutet, wobei R^{1'}, R^{2'} unabhängig von anderen Resten R^{1'}, R^{2'} im selben Molekül H, substituiertes oder nicht substituiertes C₁-C₁₀-Alkyl, substituiertes oder nicht substituiertes C₁-C₁₀-Alkenyl oder substituiertes oder nicht substituiertes C₆-C₂₀-Aryl bedeutet, wobei das C₁-C₁₀-Alkyl, das C₁-C₁₀-Alkenyl und das C₆-C₂₆-Aryl jeweils durch ein oder mehrere Stickstoff-, Sauerstoff- und/oder Schwefelatome unterbrochen sein kann,
E unabhängig von anderen Resten E im selben Molekül ein Rest der allgemeinen Formel NR2, PR2 oder OR ist, wobei jeder Rest R unabhängig von anderen Resten R im selben Molekül H, X, substituiertes oder nicht substituiertes C₁-C₁₀-Alkyl, substituiertes oder nicht substituiertes C₁-C₁₀-Alkenyl oder substituiertes oder nicht substituiertes C₆-C₂₆-Aryl bedeutet, wobei das C₁-C₁₀-Alkyl, das C₁-C₁₀-Alkenyl und das C₆-C₂₆-Aryl jeweils durch ein oder mehrere Stickstoff-, Sauerstoff- und/oder Schwefelatome unterbrochen sein kann,
Ph ein Phenylrest und
An⁻ ein beliebiges Anion ist.

2. Cupratverbindung nach Anspruch 1, **dadurch gekennzeichnet, dass** E der allgemeinen Formel (III) entspricht, wobei eine oder mehrere kovalente Bindungen zum Rest E über das in der Formel (III) dargestellte Phosphoratom ausgebildet sind: 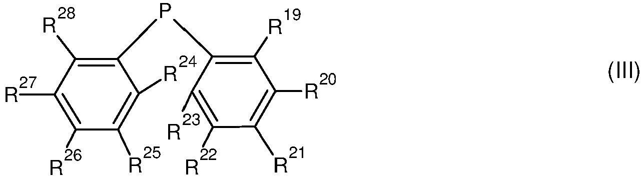 wobei
R¹⁹, R²⁰, R²¹, R²², R²³, R²⁴, R²⁵, R²⁶, R²⁷, R²⁸
H, X, substituiertes oder nicht substituiertes C₁-C₁₀-Alkyl, substituiertes oder nicht substituiertes C₁-C₁₀-Alkenyl oder substituiertes oder nicht substituiertes C₆-C₂₆-Aryl bedeutet, wobei das C₁-C₁₀-Alkyl, das C₁-C₁₀-Alkenyl und das C₆-C₂₆-Aryl jeweils durch ein oder mehrere Stickstoff-, Sauerstoff- und/oder Schwefelatome unterbrochen sein kann.

3. Cupratverbindung nach Anspruch 1 oder 2, **dadurch gekennzeichnet, dass** sie der allgemeinen Formel (I) entspricht.

4. Cupratverbindung nach einem der vorhergehenden Ansprüche, **dadurch gekennzeichnet, dass** in der Formel (I) die Reste R¹, R⁴ und R⁷ eine erste Bedeutung, die Reste R², R⁵ und R⁸ eine zweite Bedeutung sowie die Reste R³, R⁶ und R⁹ eine dritte Bedeutung aufweisen.

5. Cupratverbindung nach Anspruch 2, **dadurch gekennzeichnet, dass** in den Formeln (I) und (III) alle Reste R¹ bis R⁹ und R¹⁹ bis R²⁸ dieselbe Bedeutung aufweisen.

6. Cupratverbindung nach Anspruch 5, **dadurch gekennzeichnet, dass** alle Reste H bedeuten.

7. Cupratverbindung nach einem der vorhergehenden Ansprüche, **dadurch gekennzeichnet, dass** An⁻ ausgewählt ist aus der Gruppe bestehend aus [BF₄]⁻, PF₆⁻, AsF₆⁻, SbF₆⁻, O₃SCF₃⁻, CB₁₁H₁₂⁻, (B₁₂H₁₂)²⁻, [B(C₆F₅)]₄⁻, [B(3,5-(CF₃)₂C₆H₃]₄⁻ , Al[OC(CF₃)₃]₄⁻ und [BAr^{F}₄]⁻, wobei Ar^{F} ein Rest der allgemeinen Formel (VI) ist: 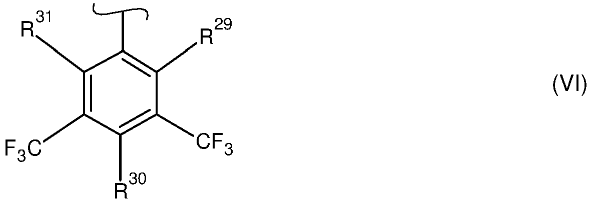 wobei
R²⁹, R³⁰, R³¹
H, X, substituiertes oder nicht substituiertes C₁-C₁₀-Alkyl, substituiertes oder nicht substituiertes C₁-C₁₀-Alkenyl oder substituiertes oder nicht substituiertes C₆-C₂₆-Aryl bedeutet, wobei das C₁-C₁₀-Alkyl, das C₁-C₁₀-Alkenyl und das C₆-C₂₆-Aryl jeweils durch ein oder mehrere Stickstoff-, Sauerstoff- und/oder Schwefelatome unterbrochen sein kann.

8. Verwendung einer Cupratverbindung nach einem der vorherigen Ansprüche als Leuchtmittel in einer organischen Leuchtdiode.

9. Organische Leuchtdiode, **gekennzeichnet durch** eine Cupratverbindung nach einem der Ansprüche 1 bis 7.

10. Verfahren zur Herstellung einer Cupratverbindung nach einem der Ansprüche 1 bis 7, **gekennzeichnet durch** die folgenden Schritte:
Umsetzen einer Verbindung der allgemeinen Formel (VII) und/oder einer Verbindung der allgemeinen Formel (VIII) und/oder einer Verbindung der allgemeinen Formel (IX) 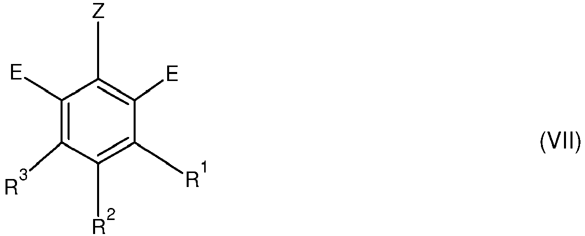 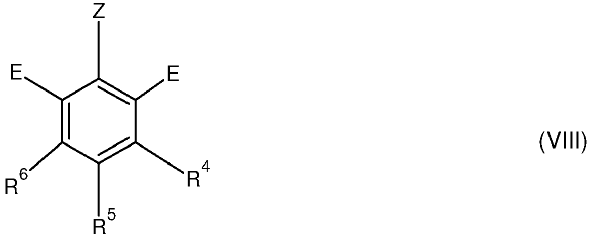 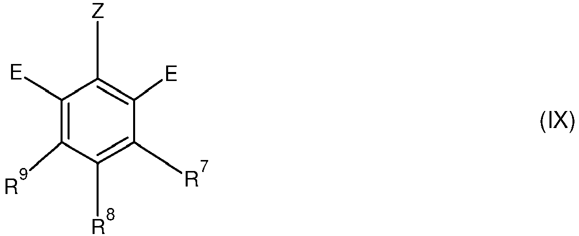 wobei
R¹, R² R³, R⁴, R⁵, R⁶, R⁷, R⁸, R⁹ H, X, substituiertes oder nicht substituiertes C₁-C₁₀-Alkyl, substituiertes oder nicht substituiertes C₁-C₁₀-Alkenyl oder substituiertes oder nicht substituiertes C₆-C₂₀-Aryl bedeutet, wobei das C₁-C₁₀-Alkyl, das C₁-C₁₀-Alkenyl und das C₆-C₂₆-Aryl jeweils durch ein oder mehrere Stickstoff-, Sauerstoff- und/oder Schwefelatome unterbrochen sein kann,
X F, Cl, Br, I, NO₂, N(R^{1'}R^{2'}) bedeutet, wobei R^{1'}, R^{2'} unabhängig von anderen Resten R^{1'}, R^{2'} im selben Molekül H, substituiertes oder nicht substituiertes C₁-C₁₀-Alkyl, substituiertes oder nicht substituiertes C₁-C₁₀-Alkenyl oder substituiertes oder nicht substituiertes C₆-C₂₀-Aryl bedeutet, wobei das C₁-C₁₀-Alkyl, das C₁-C₁₀-Alkenyl und das C₆-C₂₆-Aryl jeweils durch ein oder mehrere Stickstoff-, Sauerstoff- und/oder Schwefelatome unterbrochen sein kann,
E unabhängig von anderen Resten E im selben Molekül ein Rest der allgemeinen Formel NR2, PR2 oder OR, wobei jeder Rest R unabhängig von anderen Resten R im selben Molekül H, X, substituiertes oder nicht substituiertes C₁-C₁₀-Alkyl, substituiertes oder nicht substituiertes C₁-C₁₀-Alkenyl oder substituiertes oder nicht substituiertes C₆-C₂₆-Aryl bedeutet, wobei das C₁-C₁₀-Alkyl, das C₁-C₁₀-Alkenyl und das C₆-C₂₆-Aryl jeweils durch ein oder mehrere Stickstoff-, Sauerstoff- und/oder Schwefelatome unterbrochen sein kann,
Z Si(CH₃)₃ oder Sn((CH₂)₃CH₃)₃ bedeutet,
mit [(CH₃CN)₄Cu][An⁻], wobei An⁻ ein beliebiges Anion ist.

11. Verfahren nach Anspruch 10, **dadurch gekennzeichnet, dass** An⁻ [BF₄]⁻ bedeutet.

12. Verfahren nach Anspruch 10 oder 11, **dadurch gekennzeichnet, dass** das erhaltene Produkt mit [Kat⁺][BAr^{F}₄] umgesetzt wird, wobei Ar^{F} ein Rest der allgemeinen Formel (VI) ist: 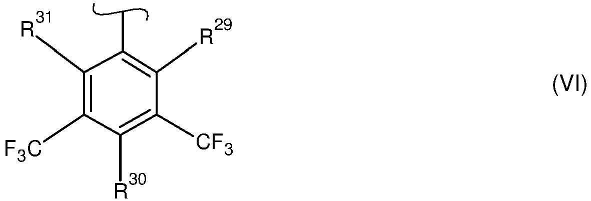 wobei
R²⁹, R³⁰, R³¹ H, X, substituiertes oder nicht substituiertes C₁-C₁₀-Alkyl, substituiertes oder nicht substituiertes C₁-C₁₀-Alkenyl oder substituiertes oder nicht substituiertes C₆-C₂₀-Aryl bedeutet, wobei das C₁-C₁₀-Alkyl, das C₁-C₁₀-Alkenyl und das C₆-C₂₀-Aryl jeweils durch ein oder mehrere Stickstoff-, Sauerstoff- und/oder Schwefelatome unterbrochen sein kann, und
Kat⁺ ein beliebiges Kation bedeutet.

## Claims

1. A cuprate compound according to one of the following formulae (I) or (XIII) 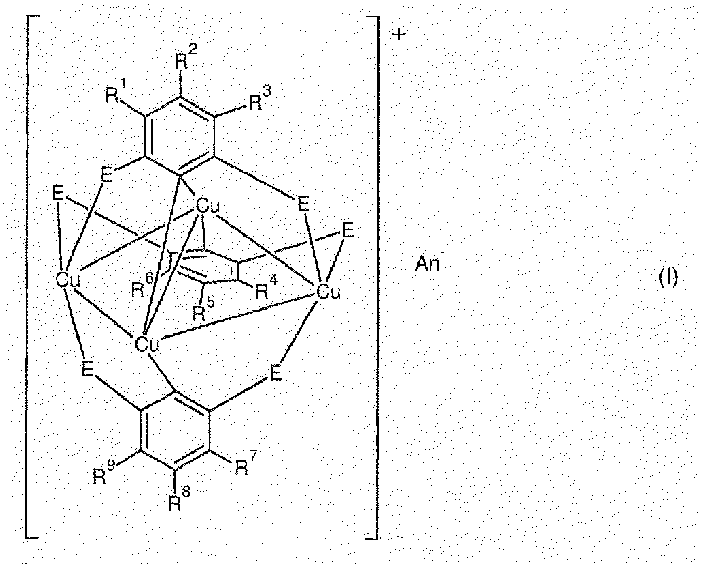 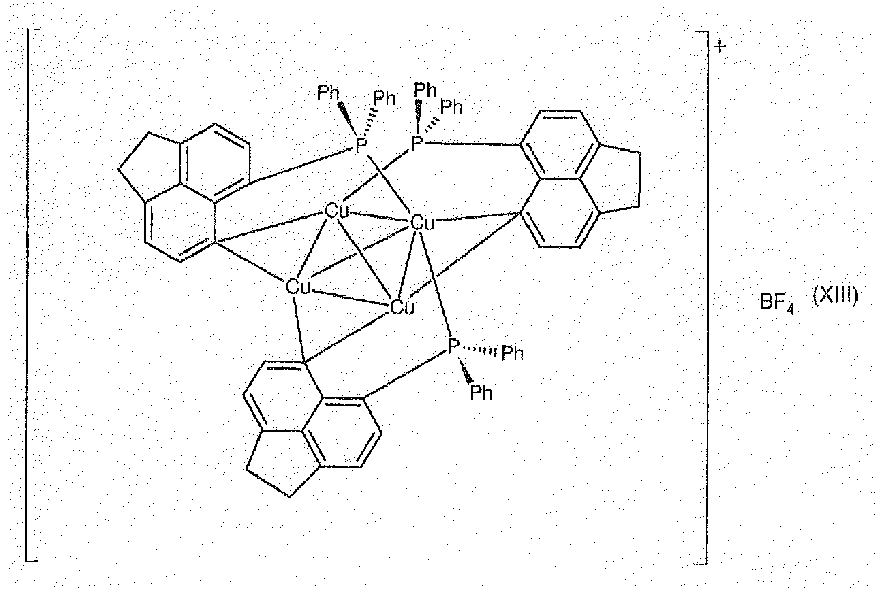 wherein
R¹, R², R³, R⁴, R⁵, R⁶, R⁷, R⁸, R⁹ H, X, means substituted or unsubstituted C₁-C₁₀-alkyl, substituted or unsubstituted C₁-C₁₀-alkenyl or substituted or unsubstituted C₆-C₂₀-aryl, wherein the C₁-C₁₀-alkyl, the C₁-C₁₀-alkenyl and the C₆-C₂₀-aryl can each be interrupted by one or more nitrogen, oxygen and/or sulfur atoms,
X means F, Cl, Br, I, NO₂, N(R^{1'}R^{2'}), wherein R^{1'}, R^{2'}, independently of other radicals R^{1'}, R^{2'} in the same molecule H, means substituted or unsubstituted C₁-C₁₀-alkyl, substituted or unsubstituted C₁-C₁₀-alkenyl or substituted or unsubstituted C₆-C₂₀-aryl, wherein the C₁-C₁₀-alkyl, the C₁-C₁₀-alkenyl and the C₆-C₂₀-aryl can each be interrupted by one or more nitrogen, oxygen and/or sulfur atoms,
E independently of other radicals E in the same molecule, is a radical of the general formula NR2, PR2 or OR, wherein each radical R, independently of other radicals R in the same molecule H, X, means substituted or unsubstituted C₁-C₁₀ alkyl, substituted or unsubstituted C₁-C₁₀ alkenyl or substituted or unsubstituted C₆-C₂₀ aryl, wherein the C₁-C₁₀ alkyl, the C₁-C₁₀ alkenyl and the C₆-C₂₀ aryl can each be interrupted by one or more nitrogen, oxygen and/or sulfur atoms,
Ph is a phenyl radical and
An⁻ is any kind of anion.

2. The cuprate compound according to claim 1, **characterized in that** E corresponds to the general formula (III), wherein one or more covalent bonds to the radical E are formed via the phosphorus atom represented in formula (III): 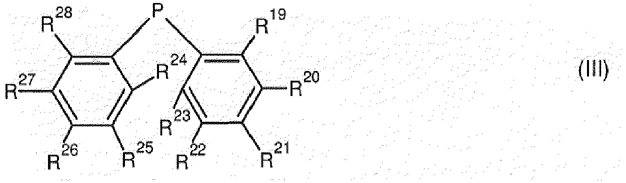 wherein
R¹⁹, R²⁰, R²¹, R²², R²³, R²⁴, R²⁵, R²⁶, R²⁷, R²⁸
H, X, means substituted or unsubstituted C₁-C₁₀-alkyl, substituted or unsubstituted C₁-C₁₀-alkenyl or substituted or unsubstituted C₆-C₂₀-aryl,wherein the C₁-C₁₀-alkyl, the C₁-C₁₀-alkenyl and the C₆-C₂₀-aryl can each be interrupted by one or more nitrogen, oxygen and/or sulfur atoms.

3. The cuprate compound according to claim 1 or 2, **characterized in that** it corresponds to the general formula (I).

4. The cuprate compound according to any of the preceding claims, **characterized in that** in formula (I) the radicals R¹, R⁴ and R7 have a first meaning, the radicals R², R⁵ and R⁸ have a second meaning and the radicals R³, R⁶ and R⁹ have a third meaning.

5. The cuprate compound according to claim 2, **characterized in that** in formulae (I) and (III) all radicals R¹ to R⁹ and R¹⁹ to R²⁸ have the same meaning.

6. The cuprate compound according to claim 5, **characterized in that** all radicals mean H.

7. The cuprate compound according to any of the preceding claims, **characterized in that** An⁻ is selected from the group consisting of [BF₄]⁻, PF₆⁻, AsF₆⁻, SbF₆⁻, O₃SCF₃⁻, CB₁₁H₁₂⁻, (B₁₂H₁₂)²⁻, [B(C₆F₅)]₄⁻, [B(3,5-(CF₃)₂C₆H₃]₄⁻, Al[OC(CF₃)₃]₄⁻ and [BAr^{F}₄]⁻, wherein Ar^{F} is a radical of the general formula (VI): 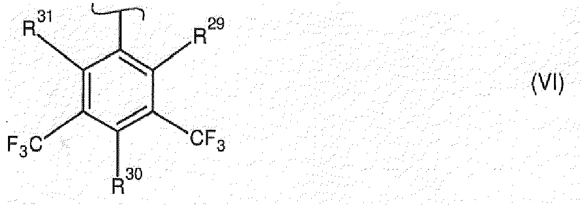 wherein
R²⁹, R³⁰, R³¹
H, X, means substituted or unsubstituted C₁-C₁₀-alkyl, substituted or unsubstituted C₁-C₁₀-alkenyl or substituted or unsubstituted C₆-C₂₀-aryl,wherein the C₁-C₁₀-alkyl, the C₁-C₁₀-alkenyl and the C₆-C₂₀-aryl can each be interrupted by one or more nitrogen, oxygen and/or sulfur atoms.

8. Use of a cuprate compound according to any of the previous claims as an illuminant in an organic light-emitting diode.

9. An organic light-emitting diode, **characterized by** a cuprate compound according to any of claims 1 to 7.

10. A method for producing a cuprate compound according to any of claims 1 to 7, **characterized by** the following steps:
reacting a compound of the general formula (VII) and/or a compound of the general formula (VIII) and/or a compound of the general formula (IX) 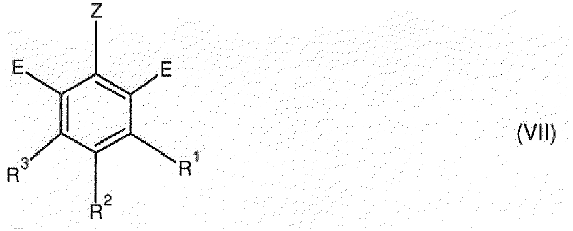 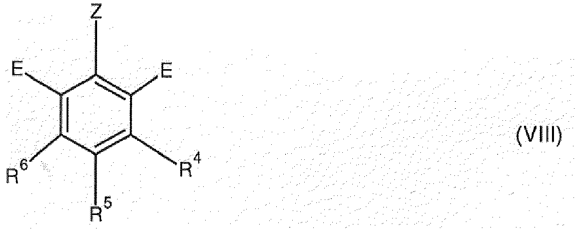 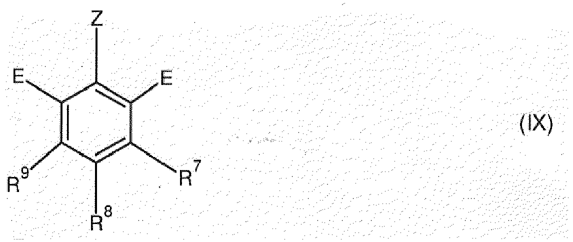 wherein
R¹, R², R³, R⁴, R⁵, R⁶, R⁷, R⁸, R⁹ H, X, means substituted or unsubstituted C₁-C₁₀-alkyl, substituted or unsubstituted C₁-C₁₀-alkenyl or substituted or unsubstituted C₆-C₂₀-aryl, wherein the C₁-C₁₀-alkyl, the C₁-C₁₀-alkenyl and the C₆-C₂₀-aryl can each be interrupted by one or more nitrogen, oxygen and/or sulfur atoms,
X means F, Cl, Br, I, NO₂, N(R^{1'}R^{2'}), wherein R^{1'}, R^{2'}, independently of other radicals R^{1'}, R^{2'} in the same molecule H, means substituted or unsubstituted C₁-C₁₀-alkyl, substituted or unsubstituted C₁-C₁₀-alkenyl or substituted or unsubstituted C₆-C₂₀-aryl,wherein the C₁-C₁₀-alkyl, the C₁-C₁₀-alkenyl and the C₆-C₂₀-aryl can each be interrupted by one or more nitrogen, oxygen and/or sulfur atoms,
E independently of other radicals E in the same molecule, is a radical of the general formula NR2, PR2 or OR, wherein each radical R, independently of other radicals R in the same molecule H, X, means substituted or unsubstituted C₁-C₁₀ alkyl, substituted or unsubstituted C₁-C₁₀ alkenyl or substituted or unsubstituted C₆-C₂₀ aryl, wherein the C₁-C₁₀ alkyl, the C₁-C₁₀ alkenyl and the C₆-C₂₀ aryl can each be interrupted by one or more nitrogen, oxygen and/or sulfur atoms,
Z means Si(CH₃)₃ or Sn((CH₂)₃CH₃)₃,
with [(CH₃CN)₄Cu][An⁻], wherein An⁻ is any kind of anion.

11. The method according to claim 10, **characterized in that** An⁻ means [BF4]⁻.

12. The method according to claim 10 or 11, **characterized in that** the product obtained is reacted with [Cat⁺][BAr^{F}₄], where Ar^{F} is a radical of the general formula (VI): 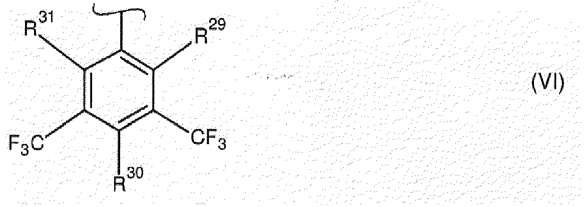 wherein
R²⁹, R³⁰, R³¹ H, X, means substituted or unsubstituted C₁-C₁₀-alkyl, substituted or unsubstituted C₁-C₁₀-alkenyl or substituted or unsubstituted C₆-C₂₀-aryl, wherein the C₁-C₁₀-alkyl, the C₁-C₁₀-alkenyl and the C₆-C₂₀-aryl can each be interrupted by one or more nitrogen, oxygen and/or sulfur atoms, and
Cat+ means any kind of cation.

## Revendications

1. Composé de cuprate selon l'une des formules (I) ou (XIII) suivantes : 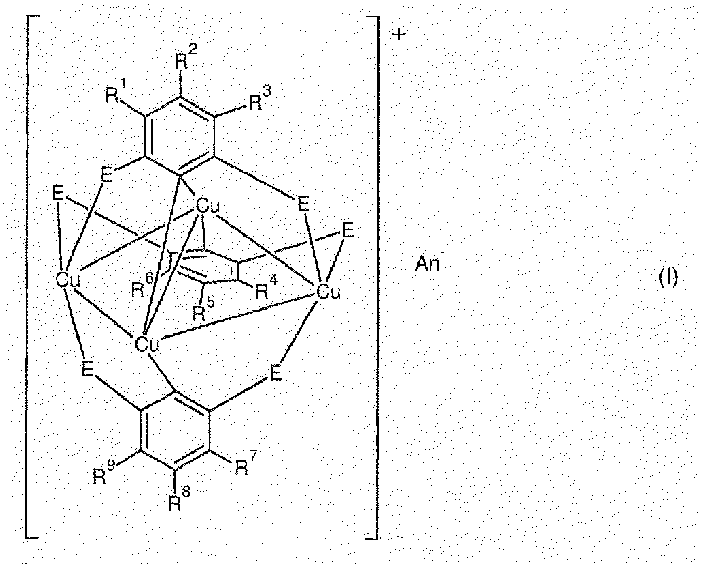 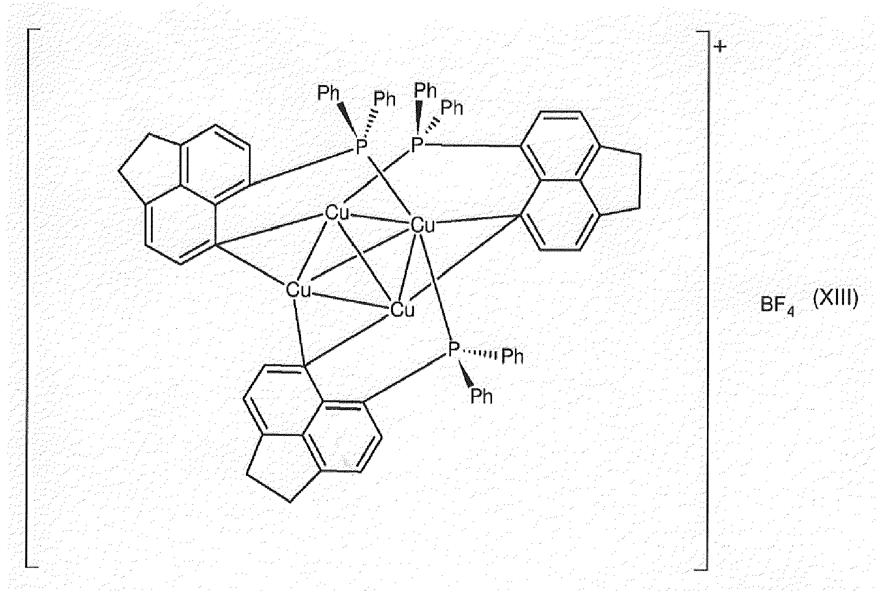 dans lequel
R¹, R², R³, R⁴, R⁵, R⁶, R⁷, R⁸, R⁹ signifie H, X, un alkyle en C₁-C₁₀ substitué ou non substitué, un alcényle en C₁-C₁₀ substitué ou non substitué ou un aryle en C₆-C₂₀ substitué ou non substitué, l'alkyle en C₁-C₁₀, l'alcényle en C₁-C₁₀ et l'aryle en C₆-C₂₀ pouvant être interrompus chacun par un ou plusieurs atomes d'azote, d'oxygène et/ou de soufre,
X représente F, Cl, Br, I, NO₂, N(R^{1'}R^{2'}), où R^{1'}, R^{2'}, indépendamment des autres radicaux R^{1'}, R^{2'} dans la même molécule signifie H, un alkyle en C₁-C₁₀ substitué ou non substitué, un alcényle en C₁-C₁₀ substitué ou non substitué ou un aryle en C₆-C₂₀ substitué ou non substitué, l'alkyle en C₁-C₁₀, l'alcényle en C₁-C₁₀ et l'aryle en C₆-C₂₀ pouvant être interrompus chacun par un ou plusieurs atomes d'azote, d'oxygène et/ou de soufre,
E indépendamment des autres radicaux E dans la même molécule est un radical de la formule générale NR2, PR2 ou OR, chaque radical R, indépendamment des autres radicaux R dans la même molécule H, X, signifiant un alkyle en C₁-C₁₀ substitué ou non substitué, un alcényle en C₁-C₁₀ substitué ou non substitué ou un aryle en C₆-C₂₀ substitué ou non substitué, l'alkyle en C₁-C₁₀, l'alcényle en C₁-C₁₀ et l'aryle en C₆-C₂₀ pouvant être interrompus chacun par un ou plusieurs atomes d'azote, d'oxygène et/ou de soufre,
Ph représente un radical phényle et
An⁻ représente un anion quelconque.

2. Composé de cuprate selon la revendication 1, **caractérisé en ce que** E correspond à la formule générale (III), dans laquelle une ou plusieurs liaisons covalentes au reste E sont formées par l'intermédiaire de l'atome de phosphore représenté dans la formule (III) : 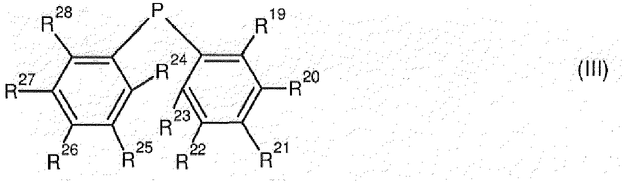 dans laquelle
R¹⁹, R²⁰, R²¹, R²², R²³, R²⁴, R²⁵, R²⁶, R²⁷, R²⁸ signifie
H, X, un alkyle en C₁-C₁₀ substitué ou non substitué, un alcényle en C₁-C₁₀ substitué ou non substitué ou un aryle en C₆-C₂₀ substitué ou non substitué, l'alkyle en C₁-C₁₀, l'alcényle en C₁-C₁₀ et l'aryle en C₆-C₂₀ pouvant être interrompus chacun par un ou plusieurs atomes d'azote, d'oxygène et/ou de soufre.

3. Composé de cuprate selon la revendication 1 ou 2, **caractérisé en ce qu'**il correspond à la formule générale (I).

4. Composé de cuprate selon l'une quelconque des revendications précédentes, **caractérisé en ce que**, dans la formule (I), les radicaux R¹, R⁴ et R⁷ ont une première signification, les radicaux R², R⁵ et R⁸ ont une deuxième signification et les radicaux R³, R⁶ et R⁹ ont une troisième signification.

5. Composé de cuprate selon la revendication 2, **caractérisé en ce que** dans les formules (I) et (III), tous les radicaux R¹ à R⁹ et R¹⁹ à R²⁸ ont la même signification.

6. Composé de cuprate selon la revendication 5, **caractérisé en ce que** tous les radicaux signifient H.

7. Composé de cuprate selon l'une quelconque des revendications précédentes, **caractérisé en ce que** An⁻ est choisi dans le groupe constitué par [BF₄]⁻, PF₆⁻, AsF₆⁻, SbF₆⁻, O₃SCF₃⁻, CB₁₁H₁₂⁻, (B₁₂H₁₂)²⁻, [B(C₆F₅)]₄⁻, [B(3,5-(CF₃)₂C₆H₃]₄⁻, Al[OC(CF₃)₃]₄⁻ et [BAr^{F}₄]⁻, où Ar^{F} est un radical de la formule générale (VI) : 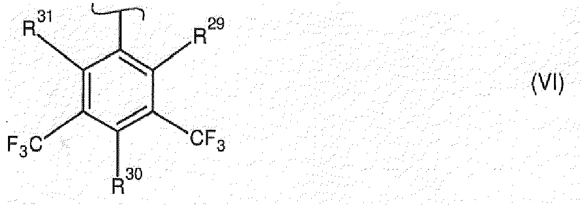 dans laquelle
R²⁹, R³⁰, R³¹ signifie
H, X, un alkyle en C₁-C₁₀ substitué ou non substitué, un alcényle en C₁-C₁₀ substitué ou non substitué ou un aryle en C₆-C₂₀ substitué ou non substitué, l'alkyle en C₁-C₁₀, l'alcényle en C₁-C₁₀ et l'aryle en C₆-C₂₀ pouvant être interrompus chacun par un ou plusieurs atomes d'azote, d'oxygène et/ou de soufre.

8. Utilisation d'un composé de cuprate selon l'une quelconque des revendications précédentes comme moyen lumineux dans une diode électroluminescente organique.

9. Diode électroluminescente organique, **caractérisée par** un composé de cuprate selon l'une quelconque des revendications 1 à 7.

10. Procédé de préparation d'un composé de cuprate selon l'une quelconque des revendications 1 à 7, **caractérisé par** les étapes suivantes :
réaction d'un composé de la formule générale (VII) et/ou d'un composé de la formule générale (VIII) et/ou d'un composé de la formule générale (IX) 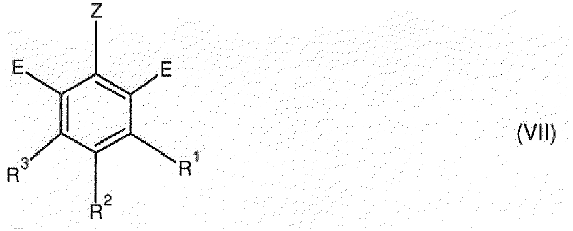 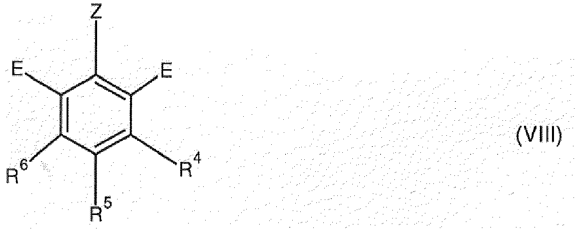 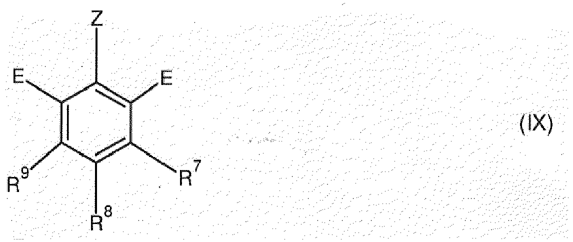 dans laquelle
R¹, R², R³, R⁴, R⁵, R⁶, R⁷, R⁸, R⁹ signifie H, X, un alkyle en C₁-C₁₀ substitué ou non substitué, un alcényle en C₁-C₁₀ substitué ou non substitué ou un aryle en C₆-C₂₀ substitué ou non substitué, l'alkyle en C₁-C₁₀, l'alcényle en C₁-C₁₀ et l'aryle en C₆-C₂₀ pouvant être interrompus chacun par un ou plusieurs atomes d'azote, d'oxygène et/ou de soufre,
X signifie F, Cl, Br, I, NO₂, N(R^{1'}R^{2'}), où R^{1'}, R^{2'}, indépendamment des autres radicaux R^{1'}, R^{2'} dans la même molécule signifie H, un alkyle en C₁-C₁₀ substitué ou non substitué, un alcényle en C₁-C₁₀ substitué ou non substitué ou un aryle en C₆-C₂₀ substitué ou non substitué, l'alkyle en C₁-C₁₀, l'alcényle en C₁-C₁₀ et l'aryle en C₆-C₂₀ pouvant être interrompus chacun par un ou plusieurs atomes d'azote, d'oxygène et/ou de soufre,
E indépendamment des autres radicaux E dans la même molécule est un radical de la formule générale NR2, PR2 ou OR, chaque radical R, indépendamment des autres radicaux R dans la même molécule signifiant H, X, un alkyle en C₁-C₁₀ substitué ou non substitué, un alcényle en C₁-C₁₀ substitué ou non substitué ou un aryle en C₆-C₂₀ substitué ou non substitué, l'alkyle en C₁-C₁₀, l'alcényle en C₁-C₁₀ et l'aryle en C₆-C₂₀ pouvant être interrompus chacun par un ou plusieurs atomes d'azote, d'oxygène et/ou de soufre,
Z signifie Si(CH₃)₃ ou Sn((CH₂)₃CH₃)₃,
avec [(CH₃CN)₄Cu][An⁻], où An⁻ est un anion quelconque.

11. Procédé selon la revendication 10, **caractérisé en ce que** An⁻ signifie [BF₄]⁻.

12. Procédé selon la revendication 10 ou 11, **caractérisé en ce que** le produit obtenu est mis à réagir avec [Cat⁺][BAr^{F}₄], où Ar^{F} est un radical de la formule générale (VI) : 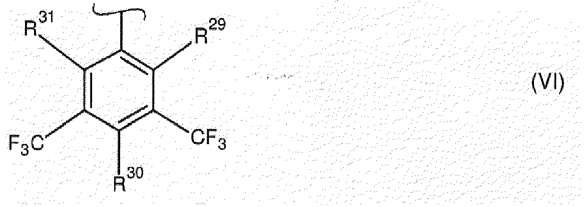 dans laquelle
R²⁹, R³⁰, R³¹ signifie H, X, un alkyle en C₁-C₁₀ substitué ou non substitué, un alcényle en C₁-C₁₀ substitué ou non substitué ou un aryle en C₆-C₂₀ substitué ou non substitué, l'alkyle en C₁-C₁₀, l'alcényle en C₁-C₁₀ et l'aryle en C₆-C₂₀ pouvant être interrompus chacun par un ou plusieurs atomes d'azote, d'oxygène et/ou de soufre,
Cat⁺ signifie un cation quelconque.
